# EUROPEAN PATENT APPLICATION

(11) **EP 4 387 252 A1**
(43) Date of publication of application: **19.06.2024**
(21) Application number: 22883163.2
(22) Date of filing: 22.06.2022
(51) Int. Cl.: H04N 23/60, G01N 21/956, G02B 7/28, G03B 13/36, G03B 15/00, H01L 21/66

(54) **AUTOFOCUS ASSISTANCE METHOD, AUTOFOCUS ASSISTANCE DEVICE, AND AUTOFOCUS ASSISTANCE PROGRAM**

(30) Priority: 20.10.2021 JP 2021171780
(71) Applicant: Hamamatsu Photonics K.K., Hamamatsu-shi, Shizuoka 435-8558 (JP)
(72) Inventor: SHIMASE, Akira, Hamamatsu-shi, Shizuoka 435-8558 (JP); TAKESHIMA, Tomochika, Hamamatsu-shi, Shizuoka 435-8558 (JP); ITO, Akari, Hamamatsu-shi, Shizuoka 435-8558 (JP)
(74) Representative: Hoffmann Eitle
(86) International application number: PCT/JP2022/024949
(87) International publication number: WO 2023/067851

(57) **Abstract**

An autofocus support method according to an embodiment supports autofocus for a semiconductor device D having a substrate and a device pattern formed on one main surface side of the substrate. The method includes: a step of acquiring a first image focused on the substrate; a step of acquiring a spatial frequency image from the first image by Fourier transform and generating mask data for masking linear patterns in the same direction on the substrate based on the spatial frequency image; a step of performing filtering on a plurality of second images, which are captured by using an imaging device while changing the focal position of the imaging device on the other main surface side of the substrate, by using the mask data; and a step of focusing the imaging device on the device pattern based on the second image after filtering.

## Description

### Technical Field

One aspect of an embodiment relates to an autofocus support method, an autofocus support device, and an autofocus support program.

### Background Art

Patent Literature 1 discloses a semiconductor device failure analyzer having an automatic wavelength adjustment function, which is to automatically set the optimal wavelength of illumination light by calculating the optimal wavelength to maximize the contrast of a reflected light image captured from the back surface side of a substrate, and an autofocus (automatic focus adjustment) function for semiconductor devices having various impurity concentrations.

### Citation List

### Patent Literature

Patent Literature 1: Japanese Unexamined Patent Publication No. 2003-232749

### Summary of Invention

### Technical Problem

Conventionally, an image of a semiconductor device as a device under test (DUT) has been acquired, and various analyses such as specifying a failure location have been performed based on the image. In addition, in recent years, it has been studied to set optimal conditions for image acquisition by polishing the surface of a substrate forming a semiconductor device to reduce the thickness of the semiconductor device substrate. When an image of a semiconductor device with a polished substrate surface is acquired by using an imaging device having an autofocus function, there is a problem that the accuracy of autofocus for a device pattern in the semiconductor device is reduced.

Therefore, it is an object of one aspect of the embodiment to provide an autofocus support method, an autofocus support device, and an autofocus support program capable of improving the accuracy of autofocus for a device pattern in a semiconductor device.

### Solution to Problem

An autofocus support method according to a first aspect of the embodiment is a method for supporting autofocus for a semiconductor device having a substrate and a device pattern formed on one main surface side of the substrate, and includes: an image acquisition step for acquiring a first image focused on the substrate; a generation step in which a spatial frequency image is acquired from the first image by Fourier transform and mask data for masking linear patterns in the same direction on the substrate is generated based on the spatial frequency image; a processing step in which a plurality of second images captured by using an imaging device while changing a focal position of the imaging device on the other main surface side of the substrate are acquired and filtering is performed on the second images by using the mask data; and a focus adjustment step for focusing the imaging device on the device pattern based on the second image after filtering.

Alternatively, an autofocus support device according to a second aspect of the embodiment includes: a stage on which a semiconductor device having a substrate and a device pattern formed on one main surface side of the substrate is placed; an imaging device having a light source for emitting light to the semiconductor device and a photodetector for detecting light from the semiconductor device; and a control unit for controlling a relative position between the stage and the imaging device. The control unit includes: an image acquisition unit that acquires a first image focused on the substrate; a generation unit that acquires a spatial frequency image from the first image by Fourier transform and generates mask data for masking linear patterns in the same direction on the substrate based on the spatial frequency image; a processing unit that acquires a plurality of second images captured by using the imaging device while changing a focal position of the imaging device on the other main surface side of the substrate and performs filtering on the second images by using the mask data; and a focus adjustment unit that focuses the imaging device on the device pattern based on the second image after filtering.

Alternatively, an autofocus support program according to a third aspect of the embodiment is an autofocus support program for supporting autofocus for a semiconductor device having a substrate and a device pattern formed on one main surface side of the substrate, and causes a computer to function as: an image acquisition unit that acquires a first image focused on the substrate; a generation unit that acquires a spatial frequency image from the first image by Fourier transform and generates mask data for masking linear patterns in the same direction on the substrate based on the spatial frequency image; a processing unit that acquires a plurality of second images captured by using an imaging device while changing a focal position of the imaging device on the other main surface side of the substrate and performs filtering on the second images by using the mask data; and a focus adjustment unit that focuses the imaging device on the device pattern based on the second image after filtering.

According to the first aspect, the second aspect, or the third aspect, a spatial frequency image is acquired from the first image focused on the substrate, and mask data for masking linear patterns in the same direction on the substrate is generated based on the spatial frequency image. Then, by performing processing using a second image after filtering based on the mask data, which is an image captured while changing the focal position, on the other main surface side of the substrate, the device pattern formed on one main surface side of the substrate is focused. In this case, linear patterns in the same direction in the second image are reduced. By adjusting the focus based on such a second image, it is possible to improve the accuracy of autofocus for the device pattern in the semiconductor device.

### Advantageous Effects of Invention

According to one aspect of the present disclosure, it is possible to improve the accuracy of autofocus for a device pattern in a semiconductor device.

### Brief Description of Drawings

FIG. 1 is a schematic configuration diagram of an autofocus support device according to an embodiment.
FIG. 2 is a diagram showing examples of a first image.
FIG. 3 is a diagram showing examples of a first image.
FIG. 4 is a diagram showing examples of a first image.
FIG. 5 is a diagram showing images for explaining an example of the generation of a spatial frequency image.
FIG. 6 is a diagram showing images for explaining mask data creation processing and inverse Fourier transform processing.
FIG. 7 is a graph showing an example of the sum of frequency components for each angle.
FIG. 8 is a diagram showing images for explaining masking width calculation processing.
FIG. 9 is a graph for explaining masking width calculation processing.
FIG. 10 is a graph for explaining masking width calculation processing.
FIG. 11 is a diagram showing images for explaining filtering processing for each focal position.
FIG. 12 is a diagram showing images for explaining filtering processing for each focal position.
FIG. 13 is a diagram showing images for explaining filtering processing for each focal position.
FIG. 14 is a diagram showing images for explaining a first example of focus adjustment.
FIG. 15 is a diagram showing images for explaining a second example of focus adjustment.
FIG. 16 is a diagram showing images for explaining an example of the generation of a spatial frequency image.
FIG. 17 is a diagram showing an image for explaining an example of the calculation of an angular component.
FIG. 18 is a graph showing an example of the sum of frequency components for each angle.
FIG. 19 is a diagram showing an image for explaining identification of a first spatial frequency domain and a second spatial frequency domain.
FIG. 20 is a graph showing an example of the sum of frequency components for each angle using a moving average.
FIG. 21 is a diagram showing examples of a second image and a second image after filtering.
FIG. 22 is a diagram showing examples of a second image and a second image after filtering.
FIG. 23 is a diagram showing examples of a second image and a second image after filtering.
FIG. 24 is a diagram showing examples of a second image and a second image after filtering.
FIG. 25 is a diagram showing examples of a second image and a second image after filtering.
FIG. 26 is a diagram showing examples of a second image and a second image after filtering.
FIG. 27 is a flowchart showing an example of the operation procedure of the autofocus support device.
FIG. 28 is a diagram showing images for explaining an autofocus function according to a comparative example.
FIG. 29 is a graph for explaining the autofocus function according to the comparative example.
FIG. 30 is a graph for explaining the influence between two maximum values of an autofocus index value according to the comparative example.
FIG. 31 is a graph showing a calculation result of the shift amount according to the comparative example.
FIG. 32 is a diagram showing variations of mask data.
FIG. 33 is a diagram showing images for explaining an example of the generation of a spatial frequency image.
FIG. 34 is a diagram showing images for explaining an example of filtering processing.
FIG. 35 is a diagram showing images for explaining an example of filtering processing.
FIG. 36 is a diagram showing images for explaining an example of filtering processing.
FIG. 37 is a diagram showing images for explaining an example of filtering processing.

### Description of Embodiments

Hereinafter, preferred embodiments of the present disclosure will be described in detail with reference to the diagrams. In addition, the same or equivalent portions in the diagrams are denoted by the same reference numerals, and repeated descriptions thereof will be omitted.

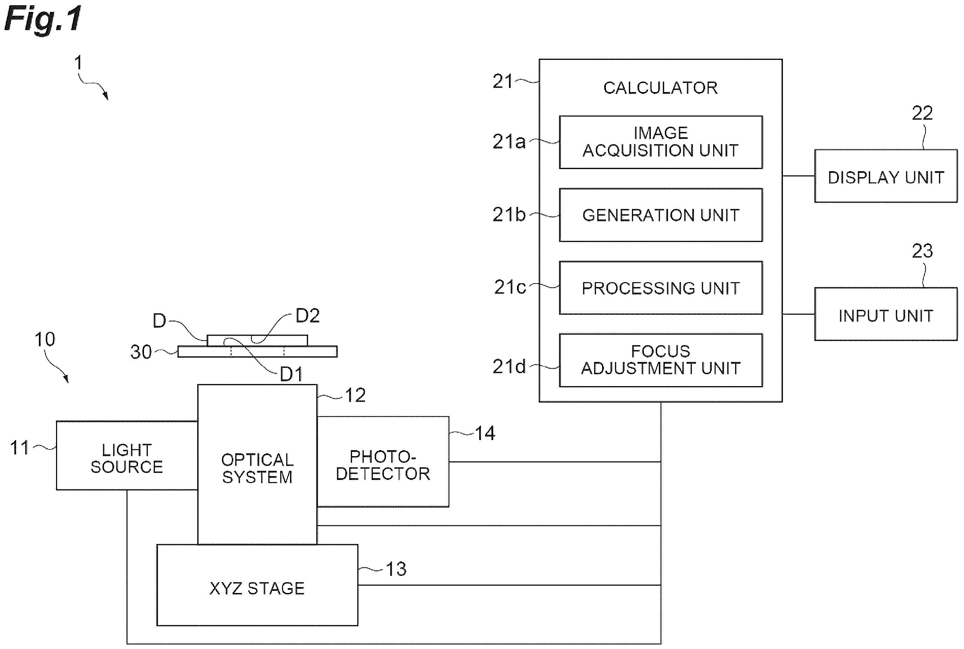

FIG. 1 is a schematic configuration diagram of an autofocus support device 1 according to an embodiment. The autofocus support device 1 is a device for supporting an autofocus function used when acquiring an image of a semiconductor device D. The acquired image is used for analysis of the semiconductor device D. The analysis of the semiconductor device D is, for example, specifying a failure location included in the semiconductor device D, but is not limited thereto. The analysis of the semiconductor device D includes other analyses, inspections, and the like regarding the semiconductor device D.

As the semiconductor device D, there are an individual semiconductor element (discrete) including a diode or a power transistor, an optoelectronic element, a sensor/actuator, a logic LSI (Large Scale Integration) formed by transistors having a MOS (Metal-Oxide-Semiconductor) structure or a bipolar structure, a memory element, a linear IC (Integrated Circuit), a hybrid device thereof, and the like. In addition, the semiconductor device D may be a package including a semiconductor device, a composite substrate, and the like.

The semiconductor device D has a stacked structure including a substrate and a metal layer. As a substrate of the semiconductor device D, for example, silicon, SiC (silicon carbide), and GaN (gallium nitride) are used. The substrate of the semiconductor device D in the present embodiment is formed of silicon and has a thickness (for example, 200 µm) that meets the functional requirements of the device. A device pattern is formed on a front surface D2 (one main surface) of the substrate. A back surface D1 (the other main surface) of the substrate is polished so that a plurality of linear polishing scratches are formed in the same direction. The semiconductor device D is placed on a sample stage 30.

The autofocus support device 1 includes an imaging device 10, an XYZ stage 13, a calculator 21, a display unit 22, and an input unit 23. The imaging device 10 includes a light source 11, an optical system 12, and a photodetector 14.

The light source 11 outputs light for illuminating the semiconductor device D. The light source 11 is, for example, an LED (Light emitting diode) or a lamp light source, and is connected to a power source (not shown). Light output from the light source 11 is guided to the optical system 12.

The optical system 12 emits the light output from the light source 11 to the semiconductor device D from the substrate side of the semiconductor device D, that is, from the back surface D1 side of the substrate of the semiconductor device D. The optical system 12 includes a beam splitter and an objective lens. The objective lens focuses the light output from the light source 11 and guided by the beam splitter onto the semiconductor device D. As the objective lens, for example, a 5x objective lens having a numerical aperture (NA) of 0.14 and a depth of focus (DOF) of 33 µm and a 20x objective lens having an NA of 0.4 and a DOF of 4.1 µm, and a 100x objective lens having an NA of 0.5 and a DOF of 2.6 µm are used. In addition, the above DOF is a calculated value when the wavelength of light is 1.3 µm.

The optical system 12 is placed on the XYZ stage 13. The XYZ stage 13 moves the optical system 12 in the Z-axis direction, which is the optical axis direction of the objective lens, and in the X-axis direction and the Y-axis direction perpendicular to the Z-axis direction. The XYZ stage 13 is movable in the three axial directions described above under the control of the calculator 21. The observation area is determined by the position of the XYZ stage 13.

The optical system 12 transmits light (reflected light) reflected by the semiconductor device D to the photodetector 14 according to emitted light. As an example, the wavelength of the emitted light is 1.0 µm or more. In this case, the light passes through the silicon substrate of the semiconductor device D and is reflected by the device pattern. Then, the light reflected by the device pattern passes through the substrate again and is input to the photodetector 14 through the objective lens and the beam splitter of the optical system 12.

The photodetector 14 images the light from the semiconductor device D and outputs image data (detection signal). For example, the photodetector 14 images the light reflected from the semiconductor device D and outputs image data for creating mask data to mask a linear pattern on the substrate. As the photodetector 14, an InGaAs camera, a laser microscope, a CCD camera in which a CCD (Charge Coupled Device) image sensor is mounted, a CMOS camera in which a CMOS image sensor is mounted, and the like are used. When the photodetector 14 is an InGaAs camera, this is used together with the light source 11 that emits infrared light having a wavelength of 1.0 µm or more. When the photodetector 14 is a laser microscope, this is used together with the light source 11 that outputs a laser having a wavelength of 1.3 µm. When the photodetector 14 is a CCD camera, this is used together with the light source 11 that emits visible light.

The calculator 21 has a function as a control unit that controls the operation of the autofocus support device 1. The calculator 21 is, for example, a computer such as a personal computer. The calculator 21 is connected to the light source 11, the optical system 12, the XYZ stage 13, and the photodetector 14. In addition, the calculator 21 is connected to the display unit 22 and the input unit 23. The display unit 22 is a display device such as a display. The input unit 23 is an input device such as a keyboard and a mouse for receiving an input from the user. For example, the calculator 21 controls the relative position between the sample stage 30 and the optical system 12 by moving the XYZ stage 13 in three axial directions. The calculator 21 includes an image acquisition unit 21a, a generation unit 21b, a processing unit 21c, and a focus adjustment unit 21d.

The image acquisition unit 21a acquires a first image focused on the substrate. The first image is an image of the semiconductor device D captured from the back surface D1 side of the substrate. The adjustment of the focus in the first image can be made manually or automatically.

The generation unit 21b acquires a spatial frequency image from the first image by Fourier transform, and generates mask data for masking the linear pattern on the substrate based on the spatial frequency image.

The processing unit 21c acquires a plurality of second images captured using the imaging device 10 while changing the focal position of the imaging device 10 on the back surface D1 side of the substrate, and performs filtering on the second images by using the mask data.

The focus adjustment unit 21d focuses the imaging device 10 on the device pattern based on the second images after filtering.

The calculator 21 outputs to the display unit 22 an image (analysis image) of the semiconductor device D that is captured with the device pattern in focus. The display unit 22 displays the input analysis image. In this case, the user checks a failure location from the analysis image displayed on the display unit 22, and inputs information indicating the failure location to the input unit 23. The input unit 23 outputs information indicating the failure location, which has been received from the user, to the calculator 21.

Each functional unit of the calculator 21 is a function realized when an arithmetic processing device (processor) such as a CPU of the calculator 21 executes a computer program (autofocus support program) stored in a storage medium such as a built-in memory or a hard disk drive of the calculator 21. The arithmetic processing device of the calculator 21 causes the calculator 21 to function as each functional unit in FIG. 1 by executing this computer program, thereby sequentially performing autofocus support processing, which will be described later. Various kinds of data required for executing this computer program and various kinds of data generated by executing this computer program are stored in storage media, for example, a built-in memory or a flash memory such as a RAM (a DRAM, an SRAM, a flash memory with built-in logic, an MRAM, and the like) of the calculator 21, an SSD, and a hard disk drive.

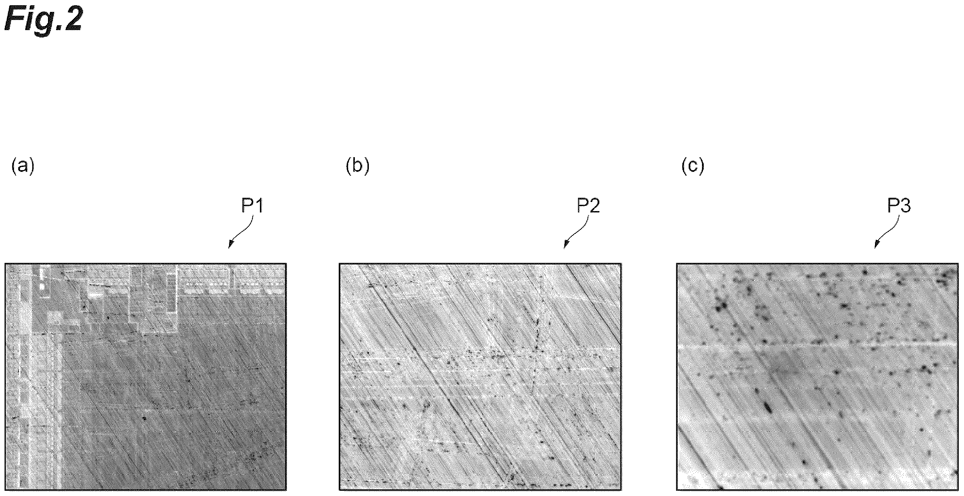

FIGS. 2 to 4 are diagrams showing examples of the first image. In addition, the first images shown in FIGS. 2 to 4 are images captured with the back surface D1 of the substrate of the semiconductor device D in focus.

Portions (a), (b), and (c) in FIG. 2 show first images P1, P2, and P3 captured by an InGaAs camera using infrared light having a wavelength of 1.0 µm or more, respectively. The first image P1, the first image P2, and the first image P3 are images captured by using a 5x objective lens, a 20x objective lens, and a 100x objective lens, respectively. In the first image P1, a device pattern appears together with polishing scratches formed on the back surface D1. Light incident on the substrate reaches farther due to the refractive index of silicon (= 3.5). For this reason, even when the focal position of the imaging device 10 is located on the back surface D1, a device pattern may appear as in the first image P1 according to conditions such as DOF = 33 µm and substrate thickness = 200 µm. On the other hand, in the first image P2 and the first image P3, almost no device pattern appears, and polishing scratches formed on the back surface D1 appear. The 20x objective lens and the 100x objective lens have a high NA and a shallow DOF. For this reason, almost no device pattern appears in the first image P2 and the first image P3.

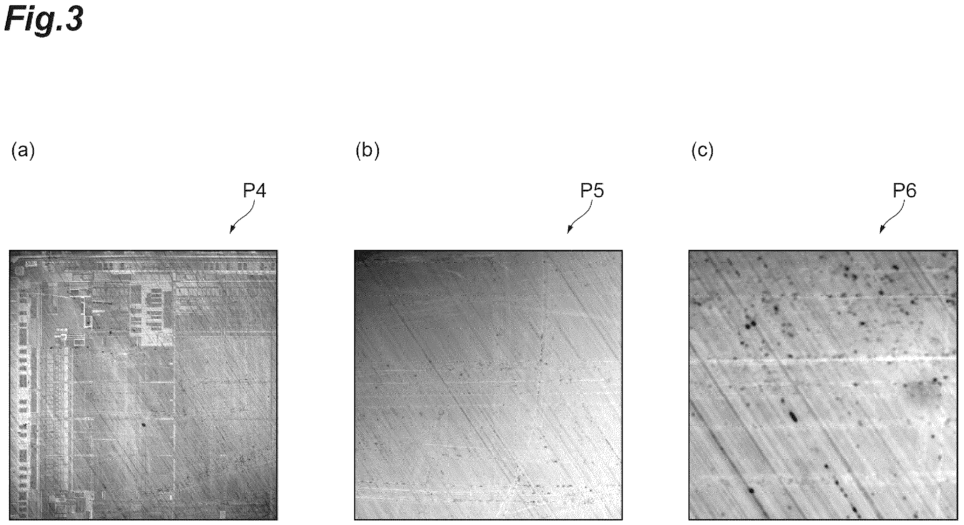

Portions (a), (b), and (c) in FIG. 3 show first images P4, P5, and P6 captured by a laser microscope using a laser beam having a wavelength of 1.3 µm, respectively. The first image P4, the first image P5, and the first image P6 are images captured by using a 5x objective lens, a 20x objective lens, and a 100x objective lens, respectively. In the first image P4, for the same reason as for the first image P1 shown portion (a) in FIG. 2, a device pattern appears together with polishing scratches formed on the back surface D1. In the first image P5 and the first image P6, for the same reason as for the first image P2 and the first image P3 shown portions (b) and (c) in FIG. 2, almost no device pattern appears, and polishing scratches formed on the back surface D1 appear.

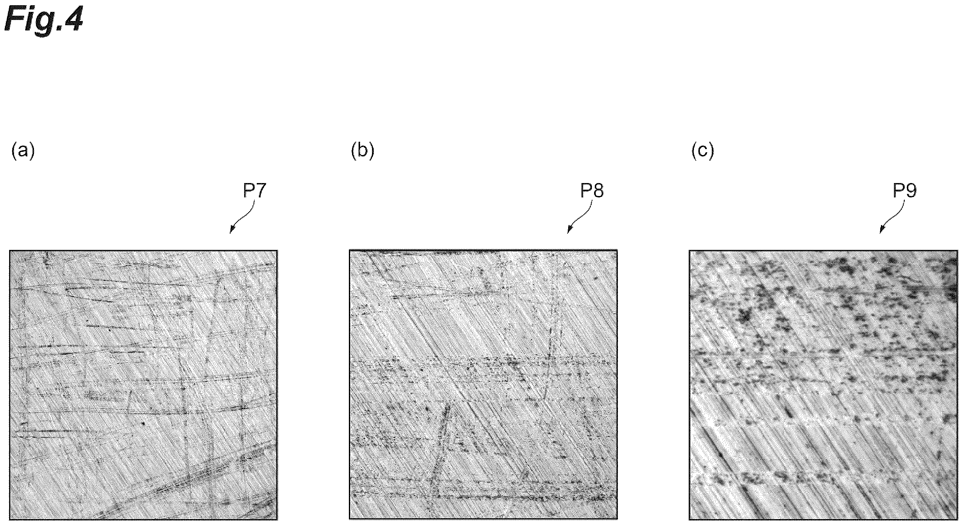

Portions (a), (b), and (c) in FIG. 4 show first images P7, P8, and P9 captured by a CCD camera using visible light, respectively. The first image P7, the first image P8, and the first image P9 are images captured by using a 5x objective lens, a 20x objective lens, and a 100x objective lens, respectively. Since visible light does not pass through the silicon substrate, no device pattern appears and polishing scratches formed on the back surface D1 appear in the first image P7, the first image P8, and the first image P9.

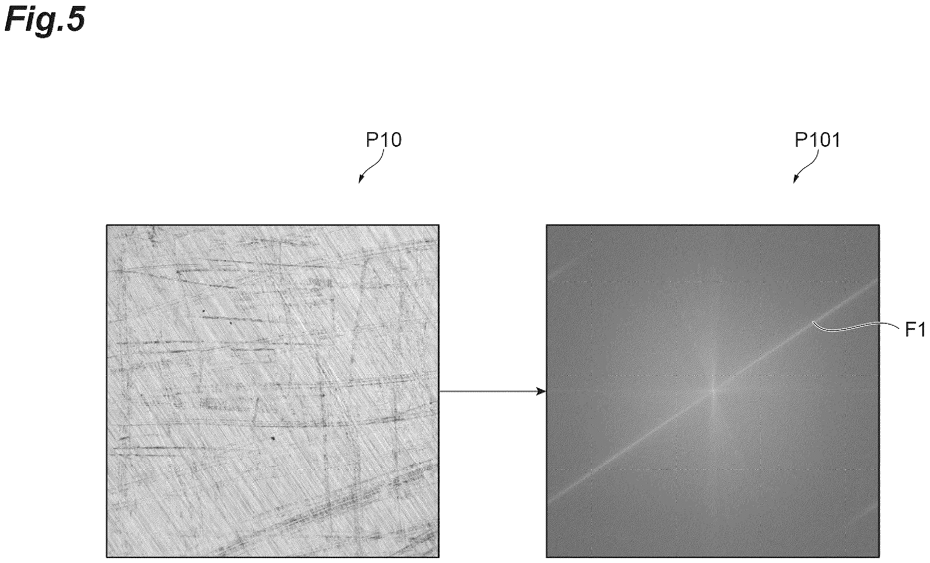

Next, an example of the processing of the generation unit 21b will be described. FIG. 5 is a diagram showing images for explaining an example of the generation of a spatial frequency image. The image P10 shown in FIG. 5 is a first image captured with the back surface D1 of the substrate in focus by using a CCD camera using a 5x objective lens and visible light. In the image P10, a plurality of polishing scratches, which are linear patterns in a specific direction (diagonal), appear in the entire image. The image P10 includes, for example, 512 × 512 pixels, and has a pixel value (brightness) in a two-dimensional coordinate system of x and y axes. The brightness at coordinates (x, y) can be expressed as f(x, y).

The generation unit 21b acquires a spatial frequency image from the first image by Fourier transform. The spatial frequency image indicates a frequency with which brightness changes occur in the first image, and has a dimension that is the reciprocal of the length. In such a spatial frequency image, features with a high frequency of brightness changes appear white. For example, the generation unit 21b acquires a spatial frequency image P101 by performing a Fourier transform on the image P10. The spatial frequency image P101 is an image showing a frequency F(u, v) with which brightness changes occur in the image P10. u and v, which correspond to the vertical and horizontal axes of the spatial frequency image P101, have a unit of Lines/ 512 pixels. As an example, the frequency F(10, 0) of one point on the spatial frequency image P101 indicates a frequency with which 10 brightness changes occur in 512 pixels in the y-axis direction of the image P10. In the spatial frequency image P101, a spatial frequency domain F1 appears as a straight white line extending diagonally.

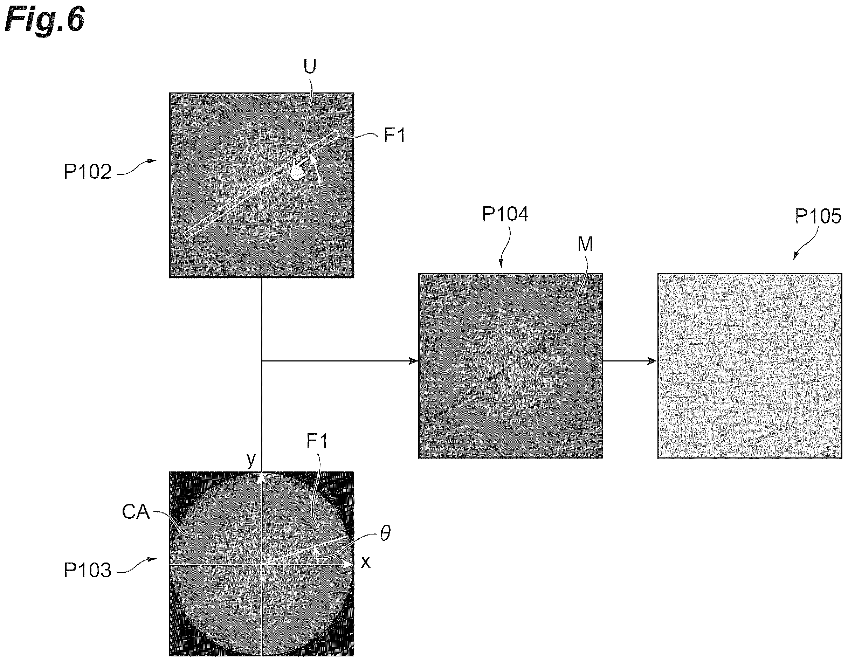

In addition, the generation unit 21b generates mask data for masking the linear pattern on the substrate based on the spatial frequency image P101. For example, the generation unit 21b identifies the spatial frequency domain F1 on the spatial frequency image P101. FIG. 6 is a diagram showing images for explaining mask data creation processing and inverse Fourier transform processing. An image P102 and an image P103 shown in FIG. 6 are examples of two images used in the process related to identification of the spatial frequency domain F1.

A first example of the identification of the spatial frequency domain F1 is angle recognition based on a user input. The image P102 is an image in which a user interface that receives a user input is displayed on the spatial frequency image P101. For example, the display unit 22 displays a rectangular frame-shaped box U passing through the center of the image P102 together with the image P102. The input unit 23 receives a user input, such as a mouse operation or the pressing of an arrow key, and rotates the box U with the center of the image P102 as a reference. For example, the input unit 23 receives a user input that matches the angle of the spatial frequency domain F1 and the angle of the box U on the image P102. Based on such a user input, the generation unit 21b identifies the spatial frequency domain F1.

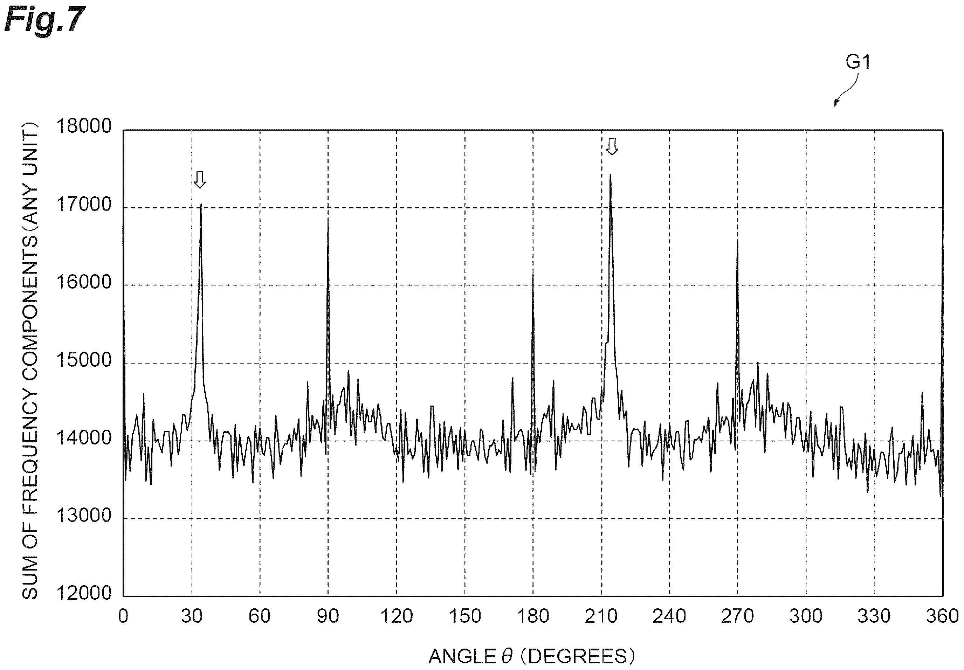

A second example of the identification of the spatial frequency domain F1 is recognition based on the calculation of frequency components for each angle. The generation unit 21b calculates the sum of frequency components for each region of a plurality of angles with respect to the central axis of the spatial frequency image P101. For example, the generation unit 21b generates the image P103 by masking the peripheral portion of the spatial frequency image P101 so as to leave a circular region CA. In addition, the generation unit 21b calculates the sum of frequency components in a range of ±0.5° for each angle θ within the circular region CA. Then, the generation unit 21b identifies the spatial frequency domain F1 from among the regions of the plurality of angles θ based on the sum of frequency components for each region of the plurality of angles θ. FIG. 7 is a graph showing an example of the sum of frequency components for each angle θ. In a graph G1, the horizontal axis indicates the angle θ, and the vertical axis indicates the sum of frequency components. In the graph G1, the sum of frequency components appears as a peak at angles θ = 34° and θ = 214° other than 0°, 90°, 180°, and 270° corresponding to vertical and horizontal patterns different from polishing scratches. The generation unit 21b identifies the peak of the sum of frequency components for each angle θ as the spatial frequency domain F1.

Subsequently, the generation unit 21b generates mask data based on the spatial frequency domain F1. The generation unit 21b generates linear mask data based on the angle (inclination) of the spatial frequency domain F1 with respect to the central axis of the spatial frequency image P101. The mask data has a predetermined masking width. The masking width may be a width set in advance or may be a width calculated by masking width calculation processing described below.

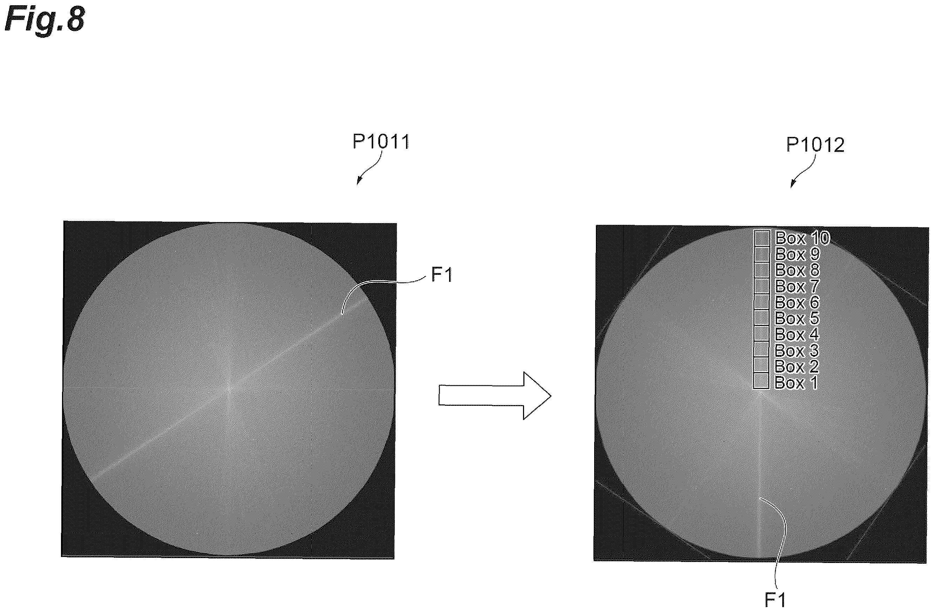

FIG. 8 is a diagram showing images for explaining the masking width calculation processing. An image P1011 is an image in which a peripheral portion of the spatial frequency image P101 is masked so as to leave a circular region. The generation unit 21b acquires an image P1012 by rotating the spatial frequency image P101 so that the spatial frequency domain F1 of the image P1011 is in the vertical axis direction. In the image P1012, boxes (Box 1 to Box 10), which are predetermined regions, are assigned in order from the center of the image to the outside of the image.

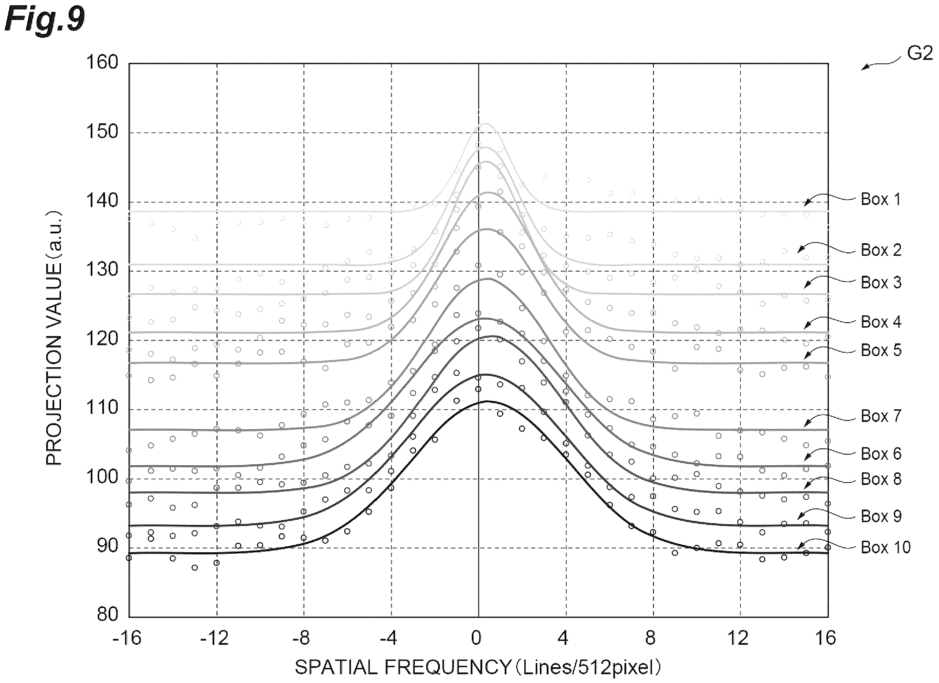

FIG. 9 is a graph for explaining the masking width calculation processing. A graph G2 is a graph obtained by calculating the profile of each box (Box 1 to Box 10) of the image P1012 shown in FIG. 8 along the horizontal axis direction. In the graph G2, the horizontal axis indicates the spatial frequency of the image P1012 in the horizontal axis direction, and the vertical axis indicates a projection value (brightness change). In addition, in the graph G2, the profile of each box is plotted as a small circle, and a result of applying a Gaussian distribution using the least squares method to each small circle is shown as a line. The Gaussian distribution spreads from Box 1 near the center of the image P1012 toward Box 10 on the outside.

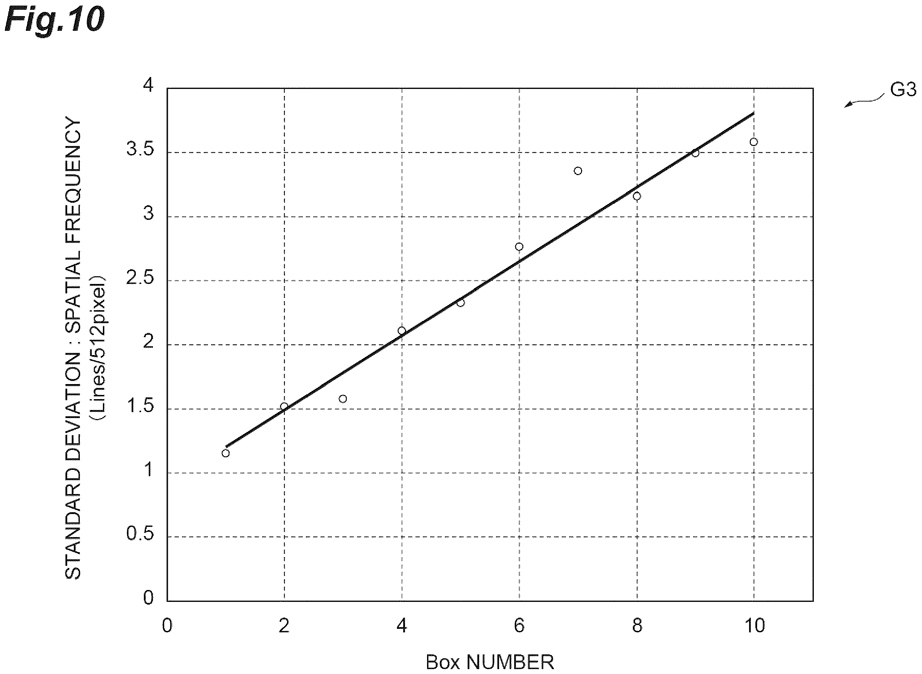

FIG. 10 is a graph for explaining the masking width calculation processing. A graph G3 shown in FIG. 10 is a graph in which the standard deviation of the Gaussian distribution shown in FIG. 9 is plotted according to the box number. In the graph G3, the horizontal axis indicates the Box number, and the vertical axis indicates the standard deviation of the Gaussian distribution. The generation unit 21b calculates as a masking width, for example, a width that is 3 times the width of the standard deviation. This masking width may include frequency components corresponding to 99.7% of polishing scratches.

Referring back to FIG. 6, filtering processing will be described. The image P104 is an image in which mask data M generated by the generation unit 21b is displayed so as to be superimposed on the spatial frequency image P101. On the image P104, the spatial frequency domain F1 on the spatial frequency image P101 and the mask data M overlap each other. Here, when an inverse Fourier transform is performed on the image P104, an image P105 after filtering is generated. The image P105 has a reduced polishing scratch pattern compared with the image P10 shown in FIG. 5.

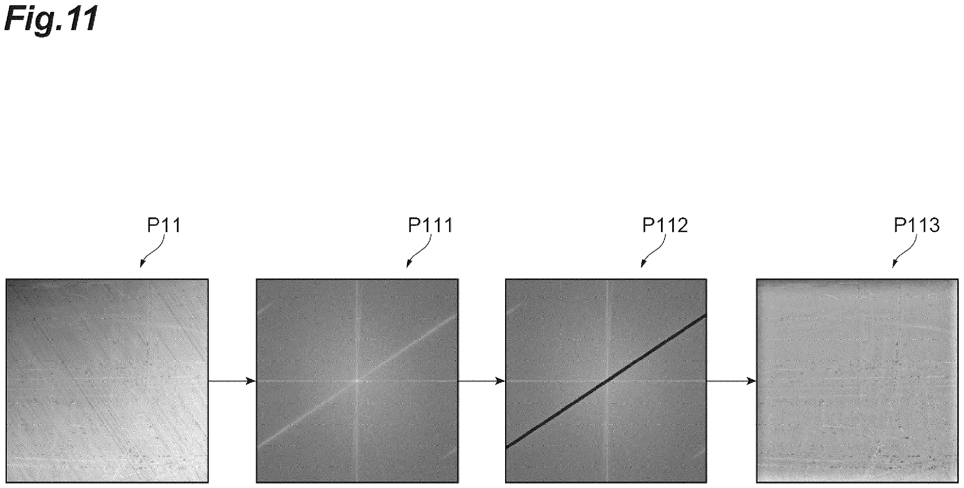

FIGS. 11 to 13 are diagrams showing images for explaining filtering processing for each focal position. The processing unit 21c acquires a plurality of second images captured by using the imaging device 10 while changing the focal position of the imaging device 10 on the back surface D1 side. The processing unit 21c changes the focal position of the imaging device 10 by moving the XYZ stage 13 in a direction approaching the sample stage 30. In addition, the processing unit 21c performs filtering on the second images by using mask data. In the filtering in FIGS. 11 to 13, common mask data is used.

An image P11 shown in FIG. 11 is a second image captured with the back surface D1 of the substrate of the semiconductor device D in focus by using a laser microscope using a 20x objective lens and a laser beam having a wavelength of 1.3 µm. In the image P11, polishing scratches formed on the back surface D1 appear. The processing unit 21c acquires a spatial frequency image P111 by performing a Fourier transform on the image P11. The processing unit 21c acquires an image P113 after filtering by performing an inverse Fourier transform on an image P112 in which mask data is superimposed on the spatial frequency image P111. The image P113 has a reduced polishing scratch pattern compared with the image P11. In addition, in the image P113, shading, which is a change in brightness and darkness in the entire image P11, has been eliminated. Eliminating such shading serves as background noise cancellation when a value obtained by normalizing the contrast value with the brightness value of the entire image is used as an autofocus index value.

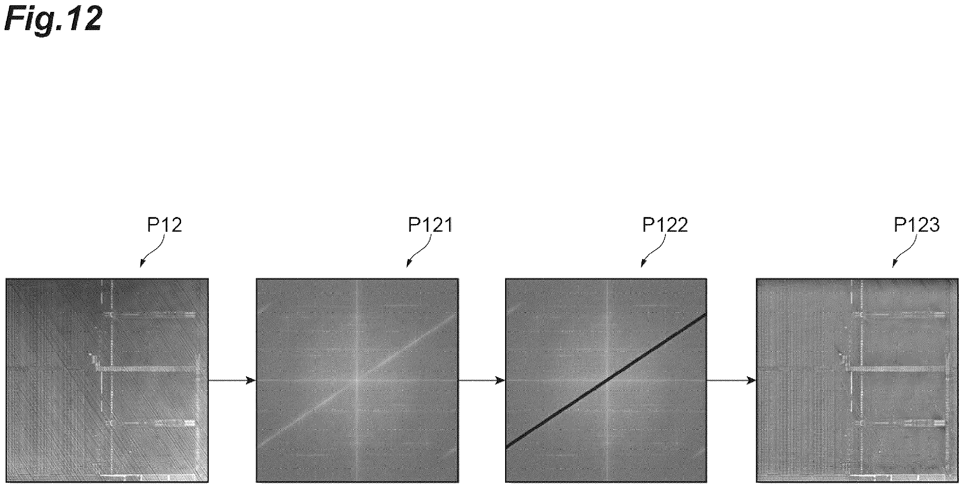

An image P12 shown in FIG. 12 is a second image captured with a focus located between the back surface D1 of the substrate of the semiconductor device D and the device pattern by using a laser microscope using a 20x objective lens and a laser beam having a wavelength of 1.3 µm. In the image P12, a device pattern appears together with the polishing scratches formed on the back surface D1. The processing unit 21c acquires a spatial frequency image P121 by performing a Fourier transform on the image P12. The processing unit 21c acquires an image P123 after filtering by performing an inverse Fourier transform on an image P122 in which mask data is superimposed on the spatial frequency image P121. Image P123 has a reduced polishing scratch pattern compared with the image P12.

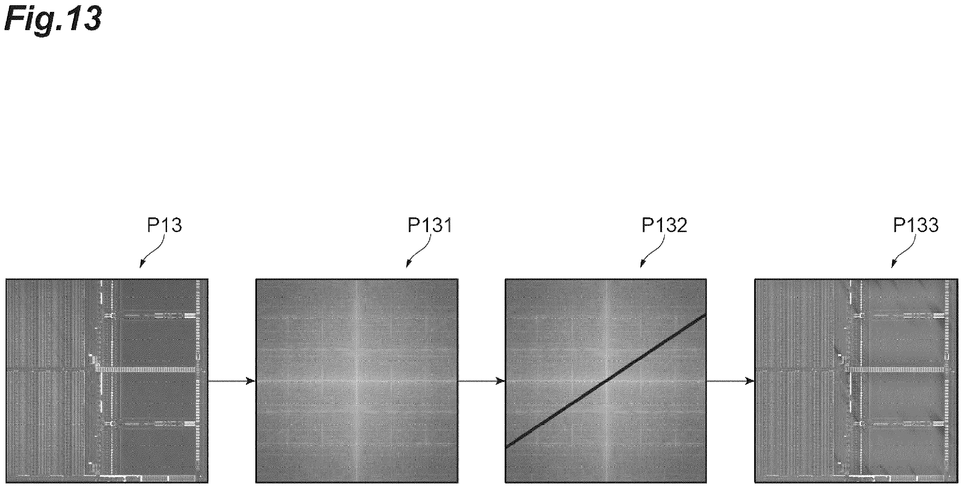

An image P13 shown in FIG. 13 is a second image captured with the device pattern of the semiconductor device D in focus by using a laser microscope using a 20x objective lens and a laser beam having a wavelength of 1.3 µm. In the image P13, slight polishing scratches formed on the back surface D1 appear together with the device pattern. The processing unit 21c acquires a spatial frequency image P131 by performing a Fourier transform on the image P13. The processing unit 21c acquires an image P133 after filtering by performing an inverse Fourier transform on an image P132 in which mask data is superimposed on the spatial frequency image P131. Image P133 has a reduced polishing scratch pattern compared with the image P13.

The focus adjustment unit 21d adjusts the focal position of the imaging device 10. For example, the focus adjustment unit 21d focuses the imaging device 10 on the device pattern based on the autofocus index value calculated from the image. As the autofocus index value, for example, a contrast value, a value obtained by normalizing the contrast value with the brightness value of the entire image, a sum of frequency components obtained by Fourier transform, and a value calculated according to the deep learning process are used. The present embodiment will be described on the assumption that the autofocus index value is a contrast value.

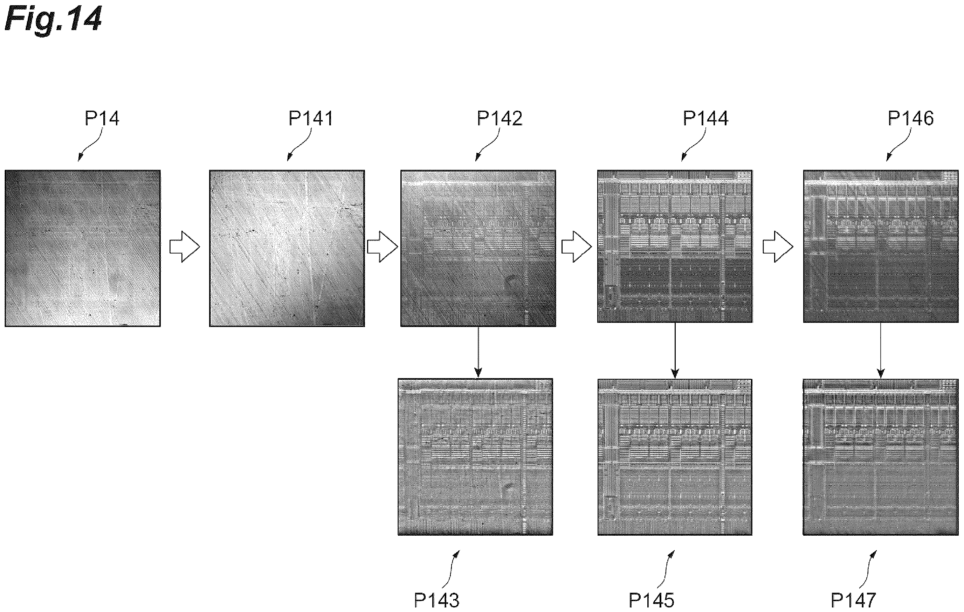

FIG. 14 is a diagram showing images for explaining a first example of focus adjustment. In the first example, a laser microscope using a 20x objective lens and a laser beam having a wavelength of 1.3 µm is used. The first example is a process in which mask data is generated while changing the focal position and focus adjustment is performed based on a second image filtered by using the mask data while changing the focal position.

The image acquisition unit 21a acquires a first image while changing the focus of the imaging device 10. The generation unit 21b acquires an autofocus index value based on the first image in order to detect a state in which the focal position is located on the back surface D1 of the substrate. Here, in an image captured with the focal position located on the back surface D1 of the substrate, the autofocus index value can reach the maximum value due to the influence of polishing scratches formed on the back surface D1.

An image P14 is a first image captured with a focus located in front of the back surface D1 of the substrate. The autofocus index value based on the image P14 is unlikely to reach the maximum value. An image P141 is a first image captured with the focal position located on the back surface D1 of the substrate. The autofocus index value based on the image P141 can be the maximum value. At the stage when the maximum value is detected, the generation unit 21b generates mask data based on the image P141. The image acquired after the generation of mask data becomes a second image.

An image P142 is a second image captured with the focal position located between the back surface D1 and the front surface D2 of the substrate. An image P143 is a second image after filtering based on the image P142. An image P144 is a second image captured with the focal position located on the device pattern formed on the front surface D2 side of the substrate. An image P145 is a second image after filtering based on the image P144. An image P146 is a second image captured with the focal position located far from the device pattern. An image P147 is a second image after filtering based on the image P146. The focus adjustment unit 21d acquires an autofocus index value based on the second image after each filtering, and focuses the imaging device 10 on the device pattern. Here, the autofocus index value of the image P145 can reach the maximum value due to the influence of the device pattern.

In the first example, the maximum value of the autofocus index value is detected twice. In the first example, since the filtering processing is performed after the first maximum value is detected, it is possible to reduce the processing load related to the filtering processing.

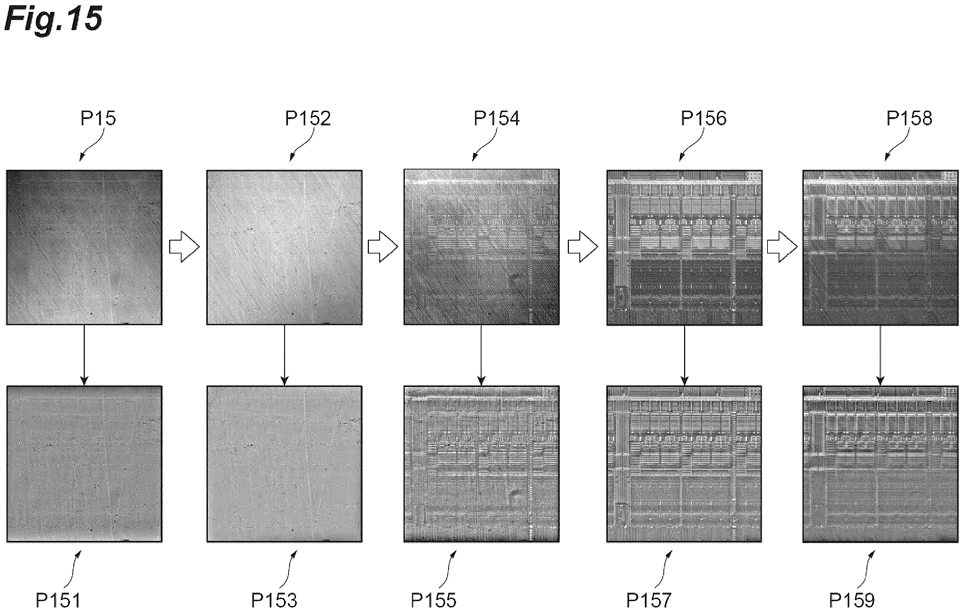

FIG. 15 is a diagram showing images for explaining a second example of focus adjustment. In the second example, as in the first example, a laser microscope using a 20x objective lens and a laser beam having a wavelength of 1.3 µm is used. The second example is a process in which filtering is performed by using mask data generated in advance and focus adjustment is performed based on a second image after filtering.

An image P15 is a second image captured with a focus located in front of the back surface D1 of the substrate. An image P151 is a second image after filtering based on the image P15. An image P152 is a second image captured with the focal position located on the back surface D1 of the substrate. An image P153 is a second image after filtering based on the image P152. An image P154 is a second image captured with the focal position located between the back surface D1 and the front surface D2 of the substrate. An image P155 is a second image after filtering based on the image P154. An image P156 is a second image captured with the focal position located on the device pattern formed on the front surface D2 side of the substrate. An image P157 is a second image after filtering based on the image P156. An image P158 is a second image captured with the focal position located far from the device pattern. An image P159 is a second image after filtering based on the image P158. The focus adjustment unit 21d acquires an autofocus index value based on the second image after filtering, and focuses the imaging device 10 on the device pattern. Here, the autofocus index value of the image P157 captured with the device pattern in focus can reach the maximum value due to the influence of the device pattern.

In the second example, the maximum value of the autofocus index value is detected once. This is because the influence of polishing scratches formed on the back surface D1 on the autofocus index value is suppressed. In the second example, the accuracy of autofocus for the device pattern is improved by detecting the maximum value of the autofocus index value with high accuracy.

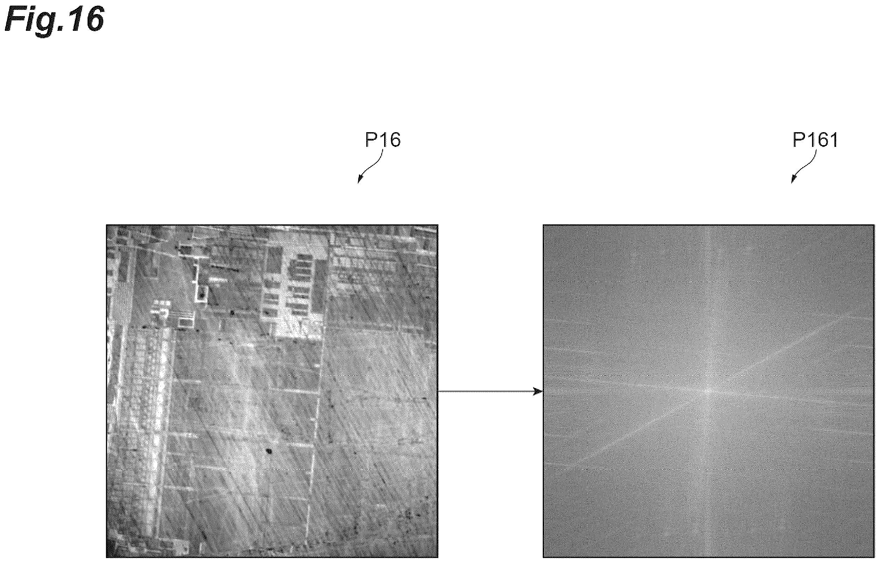

Next, an application example of the autofocus support device 1 under adverse conditions will be described with reference to FIGS. 16 to 20. FIG. 16 is a diagram showing images for explaining an example of the generation of a spatial frequency image. An image P 16 shown in FIG. 16 is a first image captured with the back surface D1 of the substrate in focus by using a laser microscope using a 5x objective lens and a laser beam having a wavelength of 1.3 µm. The semiconductor device D in the image P16 is inclined by 5° from the central axis of the image. Such an inclination is caused, for example, by the fact that the semiconductor device D is arranged on the sample stage 30 in an inclined manner. In the image P16, a device pattern appears together with polishing scratches formed on the back surface D1.

The generation unit 21b acquires a spatial frequency image P161 by performing a Fourier transform on the image P16. In the spatial frequency image P161, various white lines appear depending on a device pattern and a polishing scratch pattern.

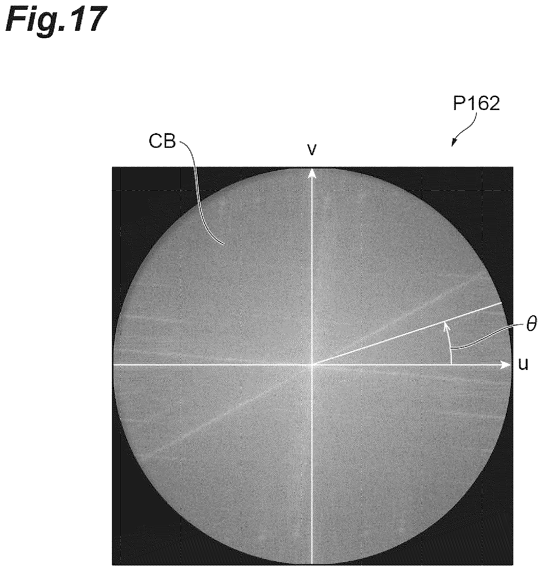

Based on the spatial frequency image P161, the generation unit 21b identifies a first spatial frequency domain corresponding to the polishing scratch pattern and a second spatial frequency domain including the device pattern. FIG. 17 is a diagram showing an image for explaining an example of the calculation of angular components. As shown in FIG. 17, the generation unit 21b generates an image P162 by masking a peripheral portion of the spatial frequency image P161 so as to leave a circular region CB. In addition, the generation unit 21b calculates the sum of frequency components in a range of ±0.5° for each angle θ within the circular region CB. Then, the generation unit 21b identifies the first spatial frequency domain from among the regions of the plurality of angles based on the sum of frequency components for each region of the plurality of angles.

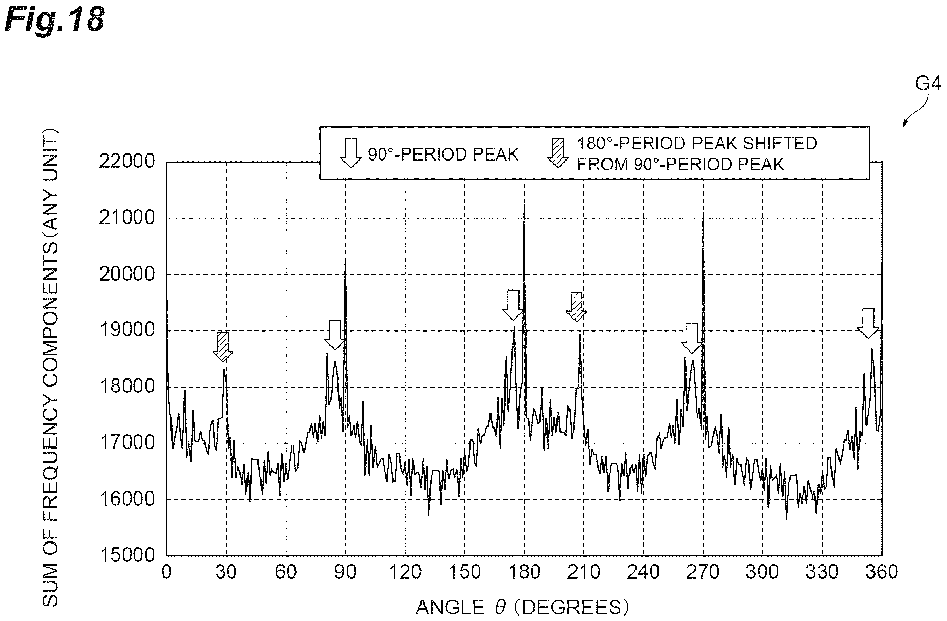

FIG. 18 is a graph showing an example of the sum of frequency components for each angle. In a graph G4, the horizontal axis indicates an angle θ, and the vertical axis indicates the sum of frequency components. In the graph G4, the sum of frequency components with a period of 180° appears as a peak at angles θ = 28.5° and θ = 208.5°. The generation unit 21b identifies the peak of the sum of frequency components with a period of 180° as a first spatial frequency domain. In addition, in the graph G4, the sum of frequency components with a period of 90° appears as a peak at angles θ = 85°, 175°, 265°, and 355° that are shifted from the UV direction of the image P162. This is because, as a property of the semiconductor device D, the device pattern is formed in the vertical and horizontal directions. The generation unit 21b identifies the peak of the sum of frequency components with a period of 90° as a second spatial frequency domain.

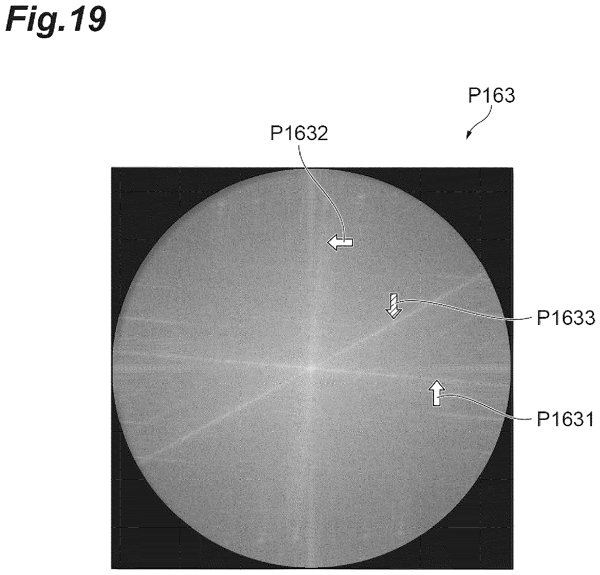

FIG. 19 is a diagram showing an image for explaining identification of the first spatial frequency domain and the second spatial frequency domain. In an image P163, a straight line P1633 indicating the first spatial frequency domain appears as a period of 180° on the image P163. Straight lines P1631 and P1632 indicating the second spatial frequency domain are perpendicular to each other and appear with a period of 90° on the image P163.

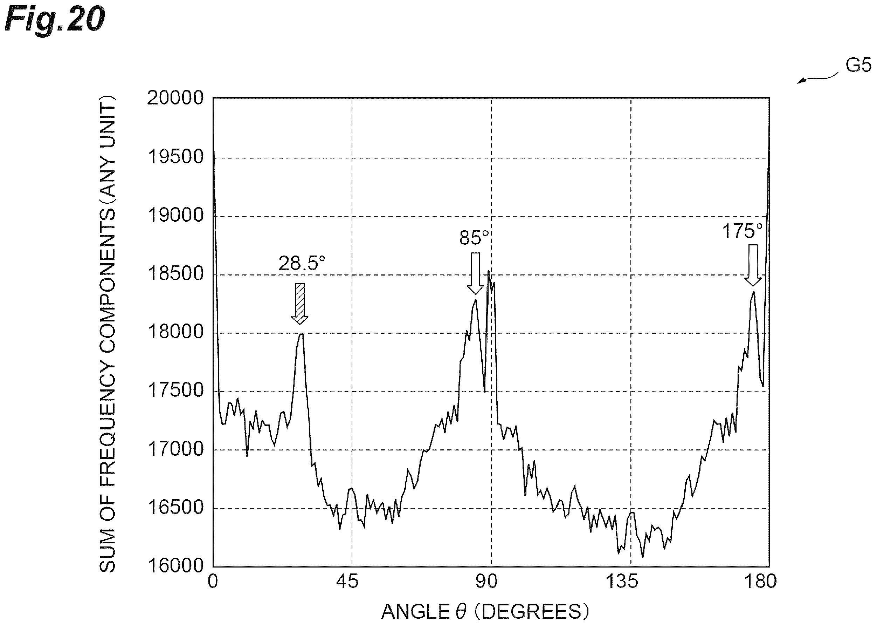

FIG. 20 is a graph showing an example of the sum of frequency components for each angle using a moving average. A graph G5 is a graph obtained by calculating the moving average of the graph G4 shown in FIG. 18 using a convolution operation. In the sum of frequency components for each angle, the angle θ = 0° to 180° and the angle θ = 180° to 360° are angular components equivalent to each other. Therefore, in the graph G5, peaks other than the angles θ = 0°, 90°, and 180° become clear. In this manner, the generation unit 21b may calculate the moving average based on the sum of frequency components for each angle by using a convolution operation.

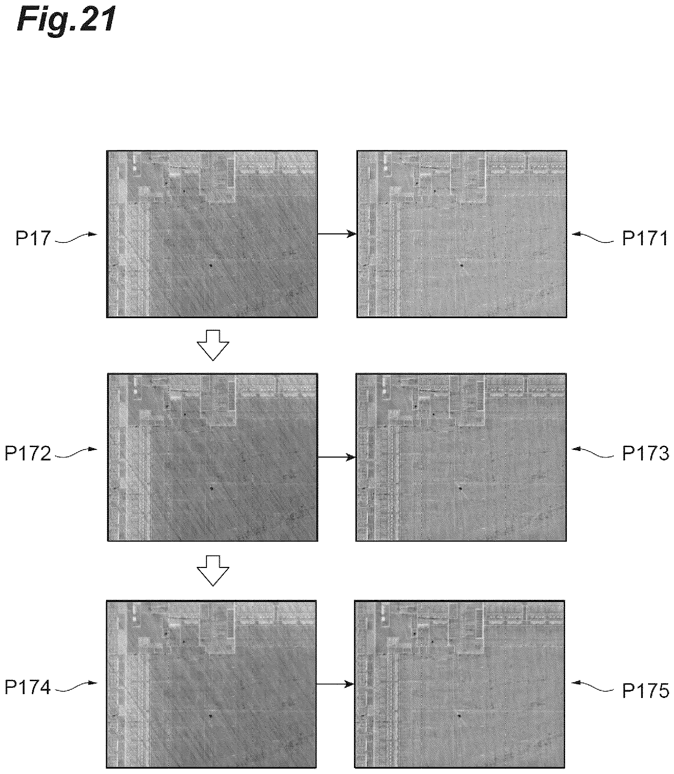

Next, examples of filtering by the autofocus support device 1 under various imaging conditions will be shown. FIGS. 21 to 26 are diagrams showing examples of a second image and a second image after filtering.

FIG. 21 is a diagram showing a second image captured by an InGaAs camera using a 5x objective lens and a second image after filtering. An image P17 is a second image captured with the focal position located between the back surface D1 and the front surface D2 of the substrate. An image P171 is a second image after filtering generated based on the image P17. An image P172 is a second image captured with the focal position located on the device pattern. An image P173 is a second image after filtering generated based on the image P172. An image P174 is a second image captured with the focal position located far from the device pattern. An image P175 is a second image after filtering generated based on the image P174. In each of the image P 17, the image P172, and the image P174, a device pattern appears together with polishing scratches. The image P171, the image P173, and the image P175 have reduced polishing scratch patterns compared with the image P17, the image P172, and the image P174 before filtering, respectively.

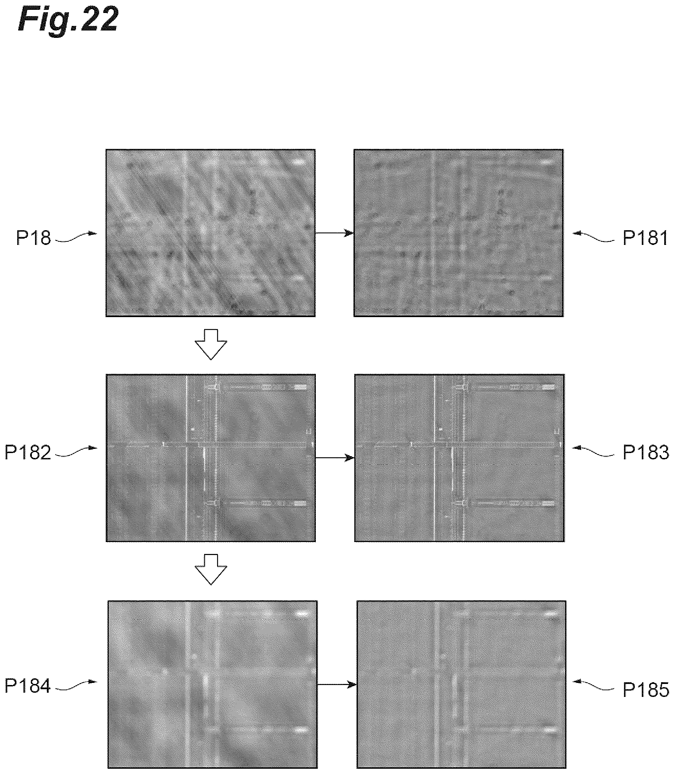

FIG. 22 is a diagram showing a second image captured by an InGaAs camera using a 20x objective lens and a second image after filtering. An image P18 is a second image captured with the focal position located between the back surface D1 and the front surface D2 of the substrate. An image P181 is a second image after filtering generated based on the image P18. An image P182 is a second image captured with the focal position located on the device pattern. An image P183 is a second image after filtering generated based on the image P182. An image P184 is a second image captured with the focal position located far from the device pattern. An image P185 is a second image after filtering generated based on the image P184. In each of the image P18, the image P182, and the image P184, a device pattern appears together with polishing scratches. The image P181, the image P183, and the image P185 have reduced polishing scratch patterns compared with the image P18, the image P182, and the image P184 before filtering, respectively.

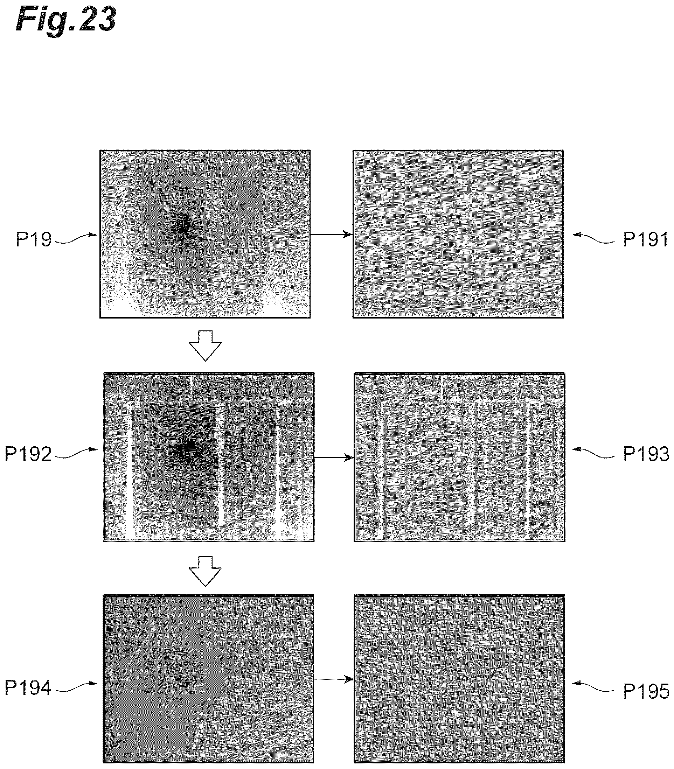

FIG. 23 is a diagram showing a second image captured by an InGaAs camera using a 100x objective lens and a second image after filtering. An image P19 is a second image captured with the focal position located between the back surface D1 and the front surface D2 of the substrate. An image P191 is a second image after filtering generated based on the image P19. An image P192 is a second image captured with the focal position located on the device pattern. An image P193 is a second image after filtering generated based on the image P192. An image P194 is a second image captured with the focal position located far from the device pattern. An image P195 is a second image after filtering generated based on the image P194. In each of the image P19, the image P192, and the image P194, a device pattern and a black dot (dust and the like) appear together with slight polishing scratches. The image P191, the image P193, and the image P195 have reduced polishing scratch patterns and reduced noise due to the black dot at the center of each image compared with the image P19, the image P192, and the image P194 before filtering, respectively.

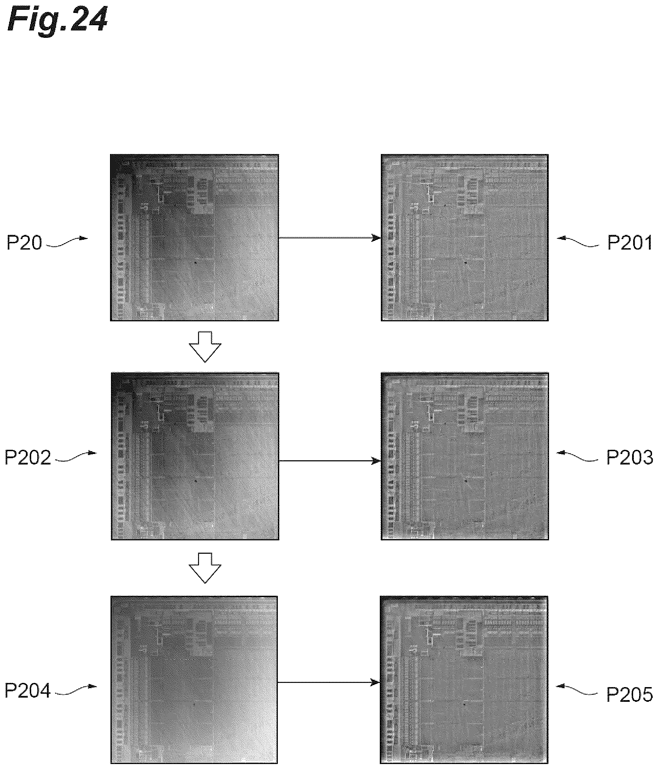

FIG. 24 is a diagram showing a second image captured by a laser microscope using a 5x objective lens and a second image after filtering. An image P20 is a second image captured with the focal position located between the back surface D1 and the front surface D2 of the substrate. An image P201 is a second image after filtering generated based on the image P20. An image P202 is a second image captured with the focal position located on the device pattern. An image P203 is a second image after filtering generated based on the image P202. An image P204 is a second image captured with the focal position located far from the device pattern. An image P205 is a second image after filtering generated based on the image P204. In each of the image P20, the image P202, and the image P204, a device pattern appears together with polishing scratches. The image P201, the image P203, and the image P205 have reduced polishing scratch patterns compared with the image P20, the image P202, and the image P204 before filtering, respectively.

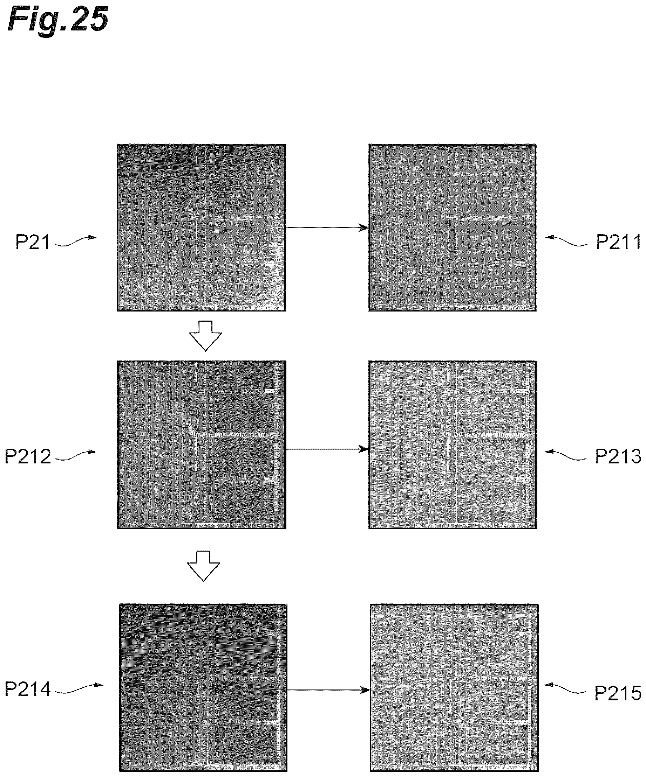

FIG. 25 is a diagram showing a second image captured by a laser microscope using a 20x objective lens and a second image after filtering. An image P21 is a second image captured with the focal position located between the back surface D1 and the front surface D2 of the substrate. An image P211 is a second image after filtering generated based on the image P21. An image P212 is a second image captured with the focal position located on the device pattern. An image P213 is a second image after filtering generated based on the image P212. An image P214 is a second image captured with the focal position located far from the device pattern. An image P215 is a second image after filtering generated based on the image P214. In each of the image P21, the image P212, and the image P214, a device pattern appears together with polishing scratches. The image P211, the image P213, and the image P215 have reduced polishing scratch patterns compared with the image P21, the image P212, and the image P214 before filtering, respectively.

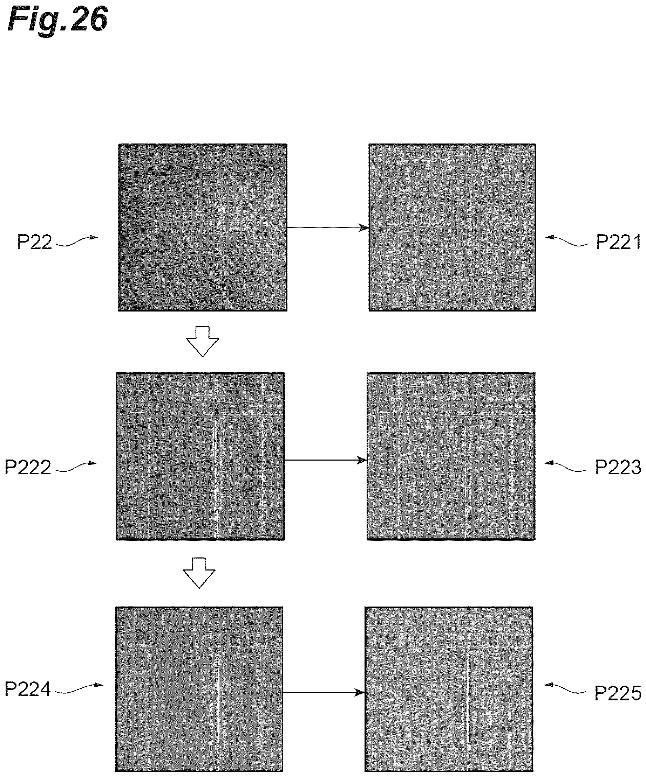

FIG. 26 is a diagram showing a second image captured by a laser microscope using a 100x objective lens and a second image after filtering. An image P22 is a second image captured with the focal position located between the back surface D1 and the front surface D2 of the substrate. An image P221 is a second image after filtering generated based on the image P22. An image P222 is a second image captured with the focal position located on the device pattern. An image P223 is a second image after filtering generated based on the image P222. An image P224 is a second image captured with the focal position located far from the device pattern. An image P225 is a second image after filtering generated based on the image P224. In each of the image P22, the image P222, and the image P224, a device pattern appears together with slight polishing scratches. The image P221, the image P223, and the image P225 have reduced polishing scratch patterns compared with the image P22, the image P222, and the image P224 before filtering, respectively.

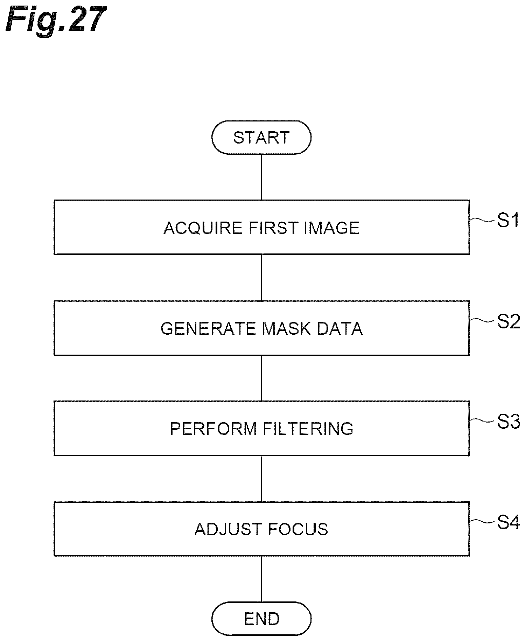

An autofocus support method according to the present embodiment will be described with reference to FIG. 27. FIG. 27 is a flowchart showing an example of the operation procedure of the autofocus support device 1.

The image acquisition unit 21a of the autofocus support device 1 acquires a first image focused on the substrate (step S 1; image acquisition step).

The generation unit 21b of the autofocus support device 1 acquires a spatial frequency image from the first image by Fourier transform, and generates mask data for masking the linear pattern on the substrate based on the spatial frequency image (step S2; generation step).

The processing unit 21c of the autofocus support device 1 acquires a plurality of second images captured by using the imaging device 10 while changing the focal position of the imaging device 10 on the back surface D1 side of the substrate, and performs filtering on the second images by using the mask data (step S3; processing step).

The focus adjustment unit 21d of the autofocus support device 1 focuses the imaging device 10 on the device pattern based on a second image after filtering (step S4; focus adjustment step).

In relation to step S1, the image acquisition unit 21a may acquire a first image captured by the imaging device 10, or may acquire a first image from another system, device, or the like.

The configuration of the imaging device 10 may be changed according to conditions such as the thickness of the substrate and the objective lens. For example, when performing focus adjustment using an objective lens with a high NA and a shallow DOF for the semiconductor device D having a thick substrate, the imaging device 10 may be an InGaAs camera using infrared light having a wavelength of 1.0 µm or more, a laser microscope using a laser beam having a wavelength of 1.3 µm, or the like. The infrared light or the light beam passes through the substrate of the semiconductor device D. Due to the high NA and the shallow DOF of the objective lens, in the first image acquired by the InGaAs camera or the laser microscope, almost no device pattern may appear, and the pattern of polishing scratches formed on the back surface D1 may clearly appear. In this case, a linear pattern on the substrate is likely to appear on the spatial frequency image. As a result, since mask data is generated more appropriately, a linear pattern in the second image can be further reduced.

When performing focus adjustment using an objective lens with a low NA and a deep DOF for the semiconductor device D having a thin substrate, the imaging device 10 may be a combination of a CCD camera using visible light and a laser microscope using a laser beam having a wavelength of 1.3 µm. A first image may be acquired by the CCD camera, and a second image may be acquired by the laser microscope. The visible light does not pass through the substrate of the semiconductor device D. For this reason, in the first image acquired by the CCD camera, no device pattern may appear, and the pattern of polishing scratches formed on the back surface D1 may clearly appear. In this case, a linear pattern on the substrate is likely to appear on the spatial frequency image. As a result, since mask data is generated more appropriately, a linear pattern in the second image can be further reduced.

Alternatively, when performing focus adjustment using an objective lens with a low NA and a deep DOF for the semiconductor device D having a thin substrate, the imaging device 10 may be an InGaAs camera using infrared light having a wavelength of 1.0 µm or more, a laser microscope using a laser beam having a wavelength of 1.3 µm, or the like. In the processing of step S1, a first image captured after switching the objective lens to an objective lens having a high NA and a shallow DOF may be acquired. The infrared light or the light beam passes through the substrate of the semiconductor device D. Due to the high NA and the shallow DOF of the objective lens, in the first image acquired by the InGaAs camera or the laser microscope, almost no device pattern may appear, and the pattern of polishing scratches formed on the back surface D1 may clearly appear. In this case, since a linear pattern on the substrate is likely to appear on the spatial frequency image, mask data is generated more appropriately. Then, the processing of step S4 may be performed after switching the objective lens to an objective lens with a low NA and a deep DOF. Even when the focus adjustment is performed by using an objective lens with a low NA and a deep DOF, a linear pattern in the second image can be further reduced because the mask data is appropriately generated.

According to the autofocus support method, the autofocus support device 1, and the autofocus support program described above, a spatial frequency image is acquired from the first image focused on the substrate, and mask data for masking linear patterns in the same direction on the substrate is generated based on the spatial frequency image. Then, by performing processing using a second image after filtering based on the mask data, which is an image captured while changing the focal position, on the back surface D1 (the other main surface) side of the substrate, the device pattern formed on the front surface D2 (one main surface) side of the substrate is focused. In this case, linear patterns in the same direction in the second image are reduced. By adjusting the focus based on such a second image, it is possible to improve the accuracy of autofocus for the device pattern in the semiconductor device D.

In the autofocus support method, in the generation step, mask data may be generated based on the first spatial frequency domain corresponding to the pattern of polishing scratches formed on the back surface D1 of the substrate. In this case, the pattern of polishing scratches in the second image is reduced. By adjusting the focus based on such a second image, it is possible to further improve the accuracy of autofocus for the device pattern in the semiconductor device D.

In the autofocus support method, in the generation step, the first spatial frequency domain and the second spatial frequency domain including the device pattern may be identified based on the spatial frequency image. In this case, the pattern of polishing scratches is more precisely reduced in the second image. By adjusting the focus based on such a second image, it is possible to further improve the accuracy of autofocus for the device pattern in the semiconductor device D.

In the autofocus support method, in the generation step, the sum of frequency components may be calculated for each region of a plurality of angles with respect to the central axis of the spatial frequency image, and the first spatial frequency domain may be identified from among the regions of the plurality of angles based on the sum of frequency components for each region of the plurality of angles. In this case, since the accuracy of specifying the angle of the mask data is improved, it is possible to further reduce the pattern of polishing scratches in the second image.

In the autofocus support method, in the image acquisition step, a first image focused on the back surface D1 of the substrate may be acquired. In this case, a linear pattern on the substrate is likely to appear on the spatial frequency image. As a result, since mask data is generated more appropriately, a linear pattern in the second image can be further reduced.

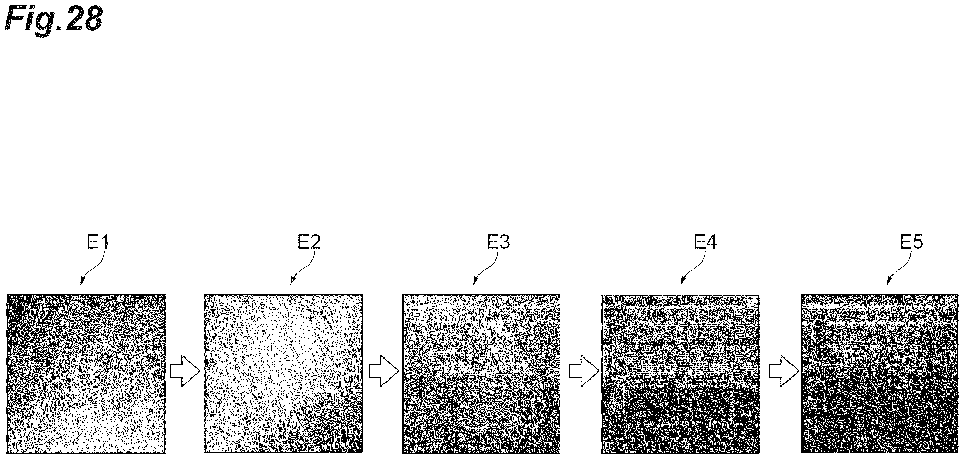

An autofocus function according to a comparative example will be described with reference to FIGS. 28 to 31. The comparative example is an example in which autofocus is performed from the back surface side of the substrate of a semiconductor device by using a conventional device having an autofocus function (hereinafter, referred to as a "conventional device").

FIG. 28 is a diagram showing images for explaining the autofocus function according to the comparative example. Images E1 to E5 are images captured by the conventional device while changing the focal position of the conventional device. Specifically, the image E1 is an image captured with the focal position located in front of the back surface of the substrate. The image E2 is an image captured with the focal position located on the back surface of the substrate. The image E3 is an image captured with the focal position located between the back surface and the front surface of the substrate. The image E4 is an image captured with the focal position located on the device pattern formed on the front surface of the substrate. The image E5 is an image captured with the focal position located far from the device pattern.

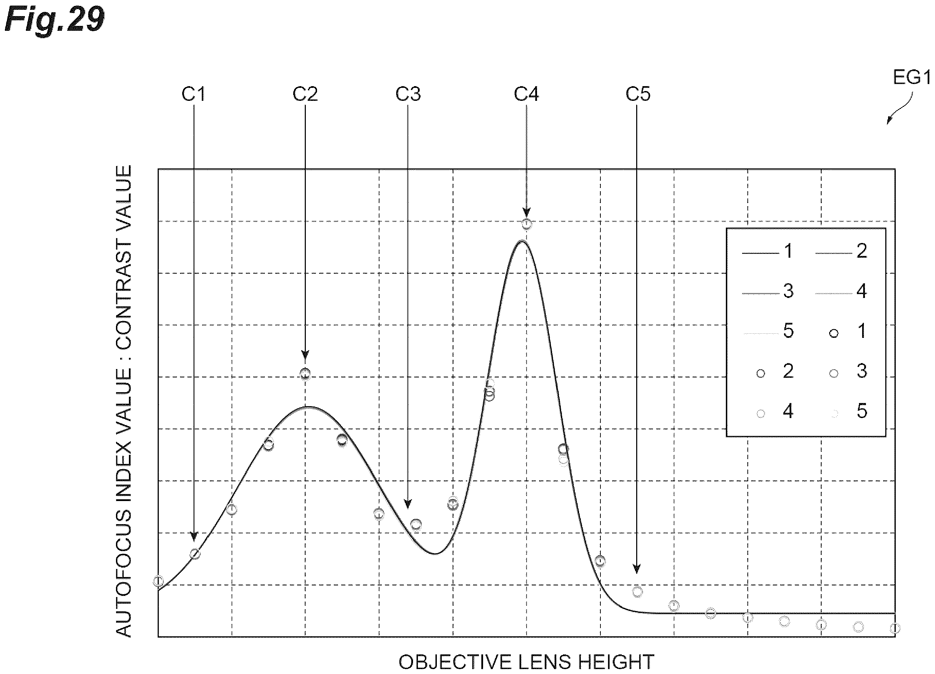

FIG. 29 is a graph for explaining the autofocus function according to the comparative example. In a graph EG1, the horizontal axis indicates the height of an objective lens, and the vertical axis indicates an autofocus index value (contrast value). In the graph EG1, a plotted marker C1 indicates an autofocus index value calculated based on the image E1 shown in FIG. 28. Similarly, markers C2, C3, C4, and C5 indicate autofocus index values calculated based on the images E2, E3, E4, and E5 shown in FIG. 28, respectively. In the graph EG1, the maximum value of the autofocus index value appears at the markers C2 and C4.

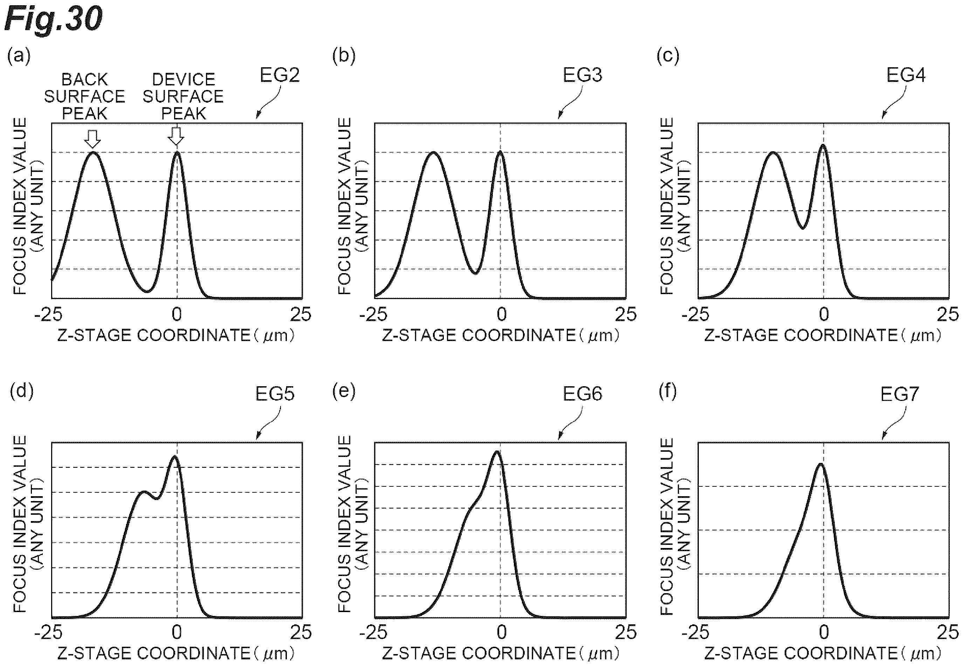

FIG. 30 is a graph for explaining the influence between two maximum values of the autofocus index value according to the comparative example. Graphs EG2 to EG7 are graphs showing the results of simulating the influence of the peak of the autofocus index value due to the pattern of polishing scratches formed on the back surface of the substrate (hereinafter, referred to as a "back surface peak") on the peak of the autofocus index value of the device surface (hereinafter, referred to as a "device surface peak") for each thickness of the substrate. In the graphs EG2 to EG7, the horizontal axis indicates a Z-stage coordinate, and the vertical axis indicates an autofocus index value. In addition, the graphs EG2 to EG7 show simulation results when the thickness of the substrate is 50 µm, 40 µm, 30 µm, 20 µm, 15 µm, and 10 µm, respectively. The simulation conditions are imaging using a 20x objective lens with NA = 0.4 and DOF = 4.1 µm, back surface peak/device surface peak = 1.0 (peak heights are the same), signal shape = Gaussian distribution, and substrate refractive index = 3.5. In addition, the device surface peak is fixed at the position of Z-stage coordinate = 0.

For example, as shown in the graph EG2, when the substrate is thick, the back surface peak and the device surface peak are separated. Therefore, the influence of the back surface pattern on the device surface peak can be neglected. As shown in the changes to the graphs EG3 to EG7, as the thickness of the substrate decreases, the back surface peak and the device surface peak are mixed. As a result, as the thickness of the substrate decreases, the influence of the back surface peak on the device surface peak increases, and the device surface peak shifts to the back surface peak side.

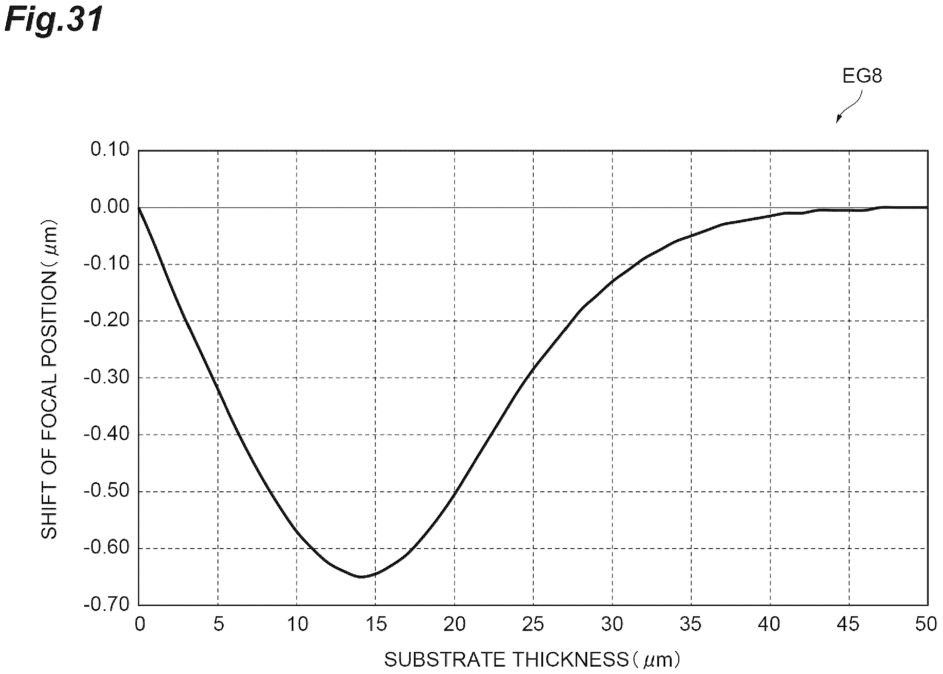

FIG. 31 is a graph showing the calculation result of the shift amount according to the comparative example. A graph EG8 is a graph showing the calculation result of the shift amount based on the simulation result shown in FIG. 30. The maximum shift amount is 0.65 µm when the substrate is 14 µm. Based on the maximum shift amount of 0.65 and a 20x objective lens (NA = 0.4, DOF = 4.1 µm), the ratio of shift to the DOF is calculated as approximately 16% using "0.65/4.1". If autofocus is performed by using a lens with a higher NA with a position shifted by 16% as a reference, it may be difficult to set an appropriate initial value for focus search. Therefore, in the autofocus function according to the comparative example, the back surface peak affects the device surface peak, which may reduce the autofocus accuracy. In contrast, in the present embodiment, the influence of the back surface peak on the device surface peak is suppressed by reducing the linear patterns in the same direction in the second image.

While various embodiments of the present disclosure have been described above, the present disclosure is not limited to the above embodiments, and may be modified or applied to other things without changing the gist of each claim.

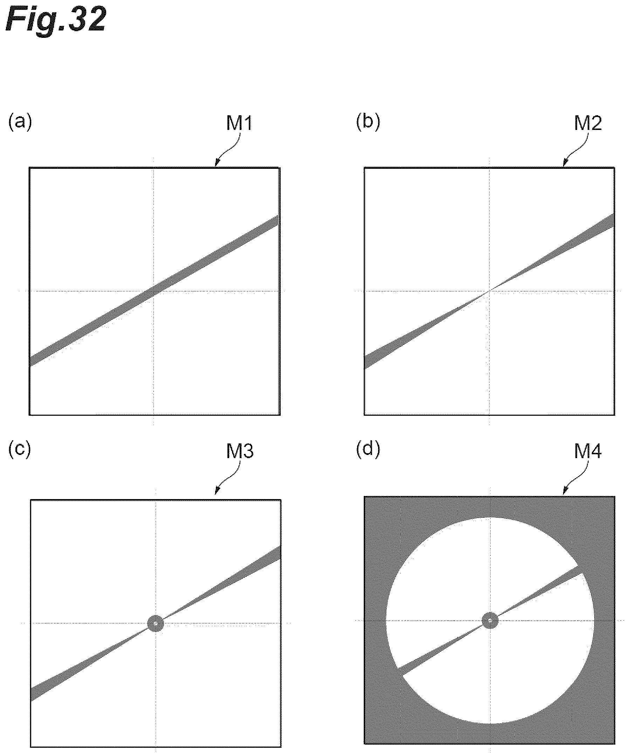

In the embodiment described above, an example has been described in which the shape of the mask data is linear, but the shape of the mask data is not limited to this. FIG. 32 is a diagram showing variations of mask data. Portions (a), (b), (c), and (d) in FIG. 32 respectively show mask data M1, M2, M3, and M4. In the mask data M1 to M4, a region close to a central portion corresponds to the low frequency component of the image, and a region close to the peripheral portion corresponds to the high frequency component of the image. As in the above embodiment, the mask data M1 extends linearly so as to pass through the central portion, and has a shape in which the masking width between the central portion and the peripheral portion is constant. The mask data M2 has a shape in which the masking width gradually decreases from the peripheral portion to the central portion. The mask data M3 has an annular mask added in the central portion in addition to the mask data M2. The annular mask surrounds the central portion. The mask data M4 has a mask added to the peripheral portion of the mask data M3.

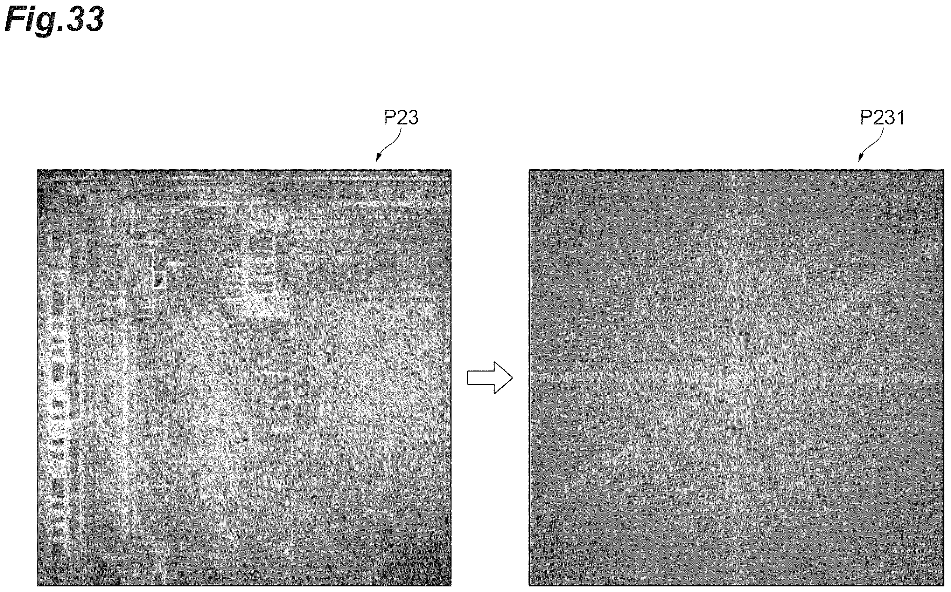

FIG. 33 is a diagram showing images for explaining an example of the generation of a spatial frequency image. An image P23 is a first image captured with the back surface D1 of the substrate in focus by using a laser microscope using a 5x objective lens and a laser beam having a wavelength of 1.3 µm. An image P231 is a spatial frequency image generated by performing a Fourier transform on the image P23.

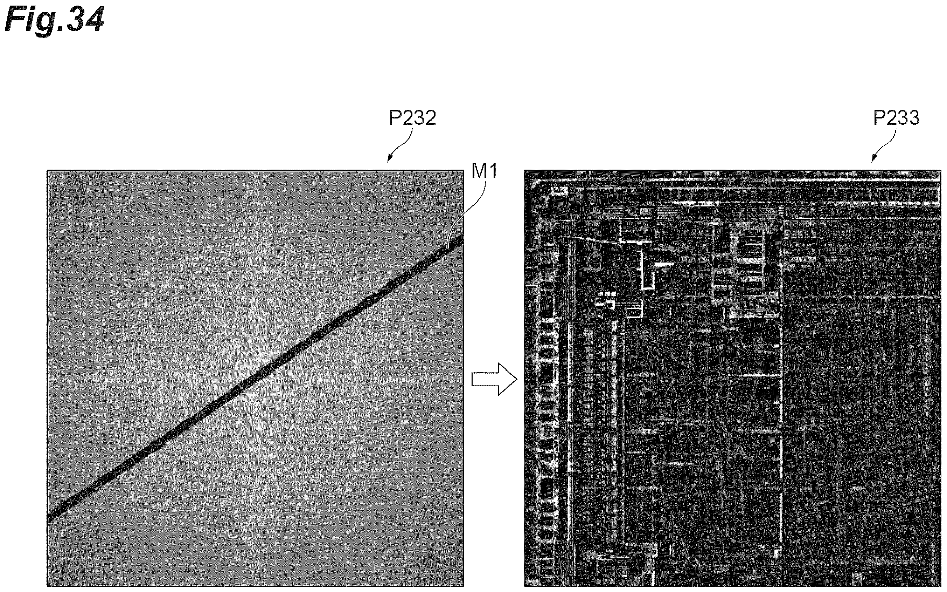

FIG. 34 is a diagram showing images for explaining an example of filtering processing. An image P232 is an image in which the mask data M1 is displayed so as to be superimposed on the image P231 shown in FIG. 33. An image P233 is an image after filtering generated by performing an inverse Fourier transform on the image P232. In the image P233, the pattern of polishing scratches formed on the back surface D1 is reduced, and macroscopic changes in light and dark are eliminated. In addition, since the zero-order term is also masked by the mask data M1, the brightness offset is reduced as a whole in the image P233. That is, the image P233 is dark as a whole compared with the image P23 before filtering (see FIG. 33).

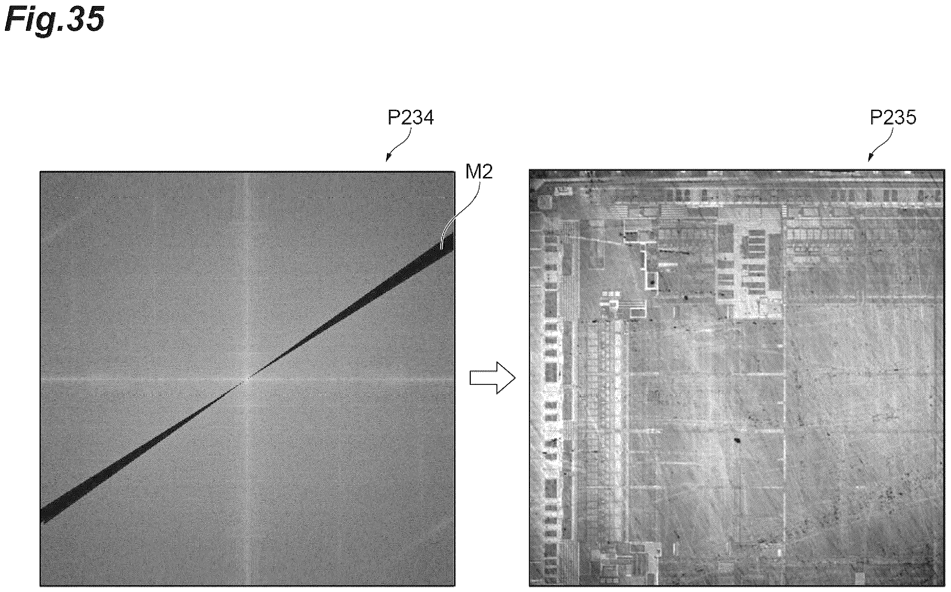

FIG. 35 is a diagram showing images for explaining an example of filtering processing. An image P234 is an image in which the mask data M2 is displayed so as to be superimposed on the image P231 shown in FIG. 33. An image P235 is an image after filtering generated by performing an inverse Fourier transform on the image P234. In the image P235, the pattern of polishing scratches formed on the back surface D1 is reduced compared with the image P23 before filtering (see FIG. 33). Since the filtering processing using the mask data M2 does not mask low frequency components, the low frequency components remain in the image P235. As a result, the overall brightness is maintained before and after filtering.

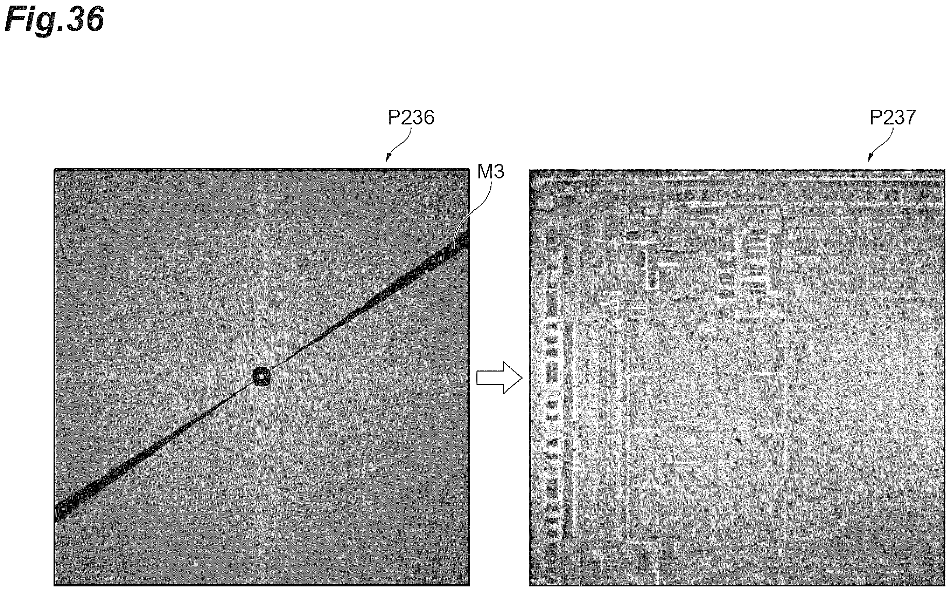

FIG. 36 is a diagram showing images for explaining an example of filtering processing. An image P236 is an image in which the mask data M3 is displayed so as to be superimposed on the image P231 shown in FIG. 33. An image P237 is an image after filtering generated by performing an inverse Fourier transform on the image P236. In the image P23 7, the pattern of polishing scratches formed on the back surface D1 is reduced compared with the image P23 before filtering (see FIG. 33). In addition to the effect of the mask data M2, the filtering processing using the mask data M3 can eliminate macroscopic non-uniform features, such as shading or waviness, if such features are included in the image.

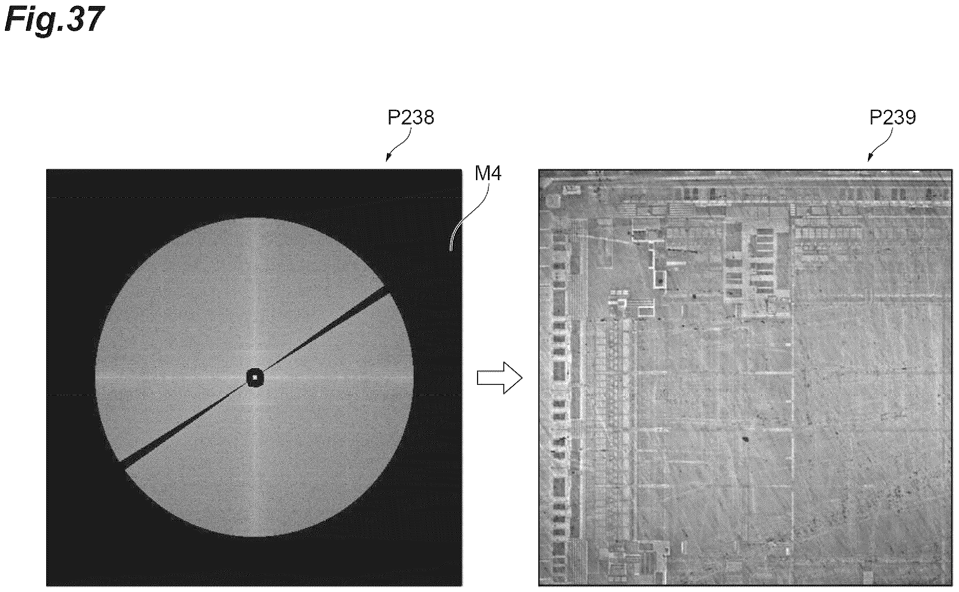

FIG. 37 is a diagram showing images for explaining an example of filtering processing. An image P238 is an image in which the mask data M4 is displayed so as to be superimposed on the image P231 shown in FIG. 33. An image P239 is an image after filtering generated by performing an inverse Fourier transform on the image P238. In the image P239, the pattern of polishing scratches formed on the back surface D1 is reduced compared with the image P23 before filtering (see FIG. 33). In addition to the effect of the mask data M3, the filtering processing using the mask data M4 can eliminate noise of higher frequency components than the device pattern.

In the embodiment described above, in the generation step, mask data may be generated based on the first spatial frequency domain corresponding to the pattern of polishing scratches formed on the other main surface side of the substrate. In this case, the pattern of polishing scratches in the second image is reduced. By adjusting the focus based on such a second image, it is possible to further improve the accuracy of autofocus for the device pattern in the semiconductor device.

In the embodiment described above, in the generation step, the first spatial frequency domain and the second spatial frequency domain including the device pattern may be identified based on the spatial frequency image. In this case, the pattern of polishing scratches in the second image is reduced more precisely. By adjusting the focus based on such a second image, it is possible to further improve the accuracy of autofocus for the device pattern in the semiconductor device.

In the embodiment described above, in the generation step, the sum of frequency components may be calculated for each region of a plurality of angles with respect to the central axis of the spatial frequency image, and the first spatial frequency domain may be identified from among the regions of the plurality of angles based on the sum of frequency components for each region of the plurality of angles. In this case, since the accuracy of specifying the angle of the mask data is improved, it is possible to further reduce the pattern of polishing scratches in the second image.

In the embodiment described above, in the image acquisition step, a first image focused on the other main surface of the substrate may be acquired. In this case, a linear pattern on the substrate is likely to appear on the spatial frequency image. As a result, since mask data is generated more appropriately, a linear pattern in the second image can be further reduced.

### Reference Signs List

1: autofocus support device, 10: imaging device, 11: light source, 12: optical system, 13: XYZ stage, 14: photodetector, 21: calculator, 21a: image acquisition unit, 21b: generation unit, 21c: processing unit, 21d: focus adjustment unit, 22: display unit, 23: input unit, 30: sample stage, D: semiconductor device, D1: back surface, D2: front surface.

## Claims

1. An autofocus support method for a semiconductor device having a substrate and a device pattern formed on one main surface side of the substrate, the autofocus support method comprising:
an image acquisition step for acquiring a first image focused on the substrate;
a generation step in which a spatial frequency image is acquired from the first image by Fourier transform and mask data for masking linear patterns in the same direction on the substrate is generated based on the spatial frequency image;
a processing step in which a plurality of second images captured by using an imaging device while changing a focal position of the imaging device on the other main surface side of the substrate are acquired and filtering is performed on the second images by using the mask data; and
a focus adjustment step for focusing the imaging device on the device pattern based on the second image after filtering.

2. The autofocus support method according to claim 1,
wherein, in the generation step, the mask data is generated based on a first spatial frequency domain corresponding to a pattern of polishing scratches formed on the other main surface side of the substrate.

3. The autofocus support method according to claim 2,
wherein, in the generation step, the first spatial frequency domain and a second spatial frequency domain including the device pattern are identified based on the spatial frequency image.

4. The autofocus support method according to claim 2 or 3,
wherein, in the generation step, a sum of frequency components is calculated for each region of a plurality of angles with respect to a central axis of the spatial frequency image, and the first spatial frequency domain is identified from among the regions of the plurality of angles based on the sum of frequency components for each region of the plurality of angles.

5. The autofocus support method according to any one of claims 1 to 4,
wherein, in the image acquisition step, the first image focused on the other main surface of the substrate is acquired.

6. An autofocus support device, comprising:
a stage on which a semiconductor device having a substrate and a device pattern formed on one main surface side of the substrate is placed;
an imaging device having a light source for emitting light to the semiconductor device and a photodetector for detecting light from the semiconductor device; and
a control unit for controlling a relative position between the stage and the imaging device,
wherein the control unit includes:
an image acquisition unit that acquires a first image focused on the substrate;
a generation unit that acquires a spatial frequency image from the first image by Fourier transform and generates mask data for masking linear patterns in the same direction on the substrate based on the spatial frequency image;
a processing unit that acquires a plurality of second images captured by using the imaging device while changing a focal position of the imaging device on the other main surface side of the substrate and performs filtering on the second images by using the mask data; and
a focus adjustment unit that focuses the imaging device on the device pattern based on the second image after filtering.

7. An autofocus support program for supporting autofocus for a semiconductor device having a substrate and a device pattern formed on one main surface side of the substrate, the program causing a computer to function as:
an image acquisition unit that acquires a first image focused on the substrate;
a generation unit that acquires a spatial frequency image from the first image by Fourier transform and generates mask data for masking linear patterns in the same direction on the substrate based on the spatial frequency image;
a processing unit that acquires a plurality of second images captured by using an imaging device while changing a focal position of the imaging device on the other main surface side of the substrate and performs filtering on the second images by using the mask data; and
a focus adjustment unit that focuses the imaging device on the device pattern based on the second image after filtering.
